(19) Europäisches Patentamt
European Patent Office
Office européen des brevets

(11) EP 4 310 524 A1

(12) EUROPEAN PATENT APPLICATION
published in accordance with Art. 153(4) EPC

(43) Date of publication:
**24.01.2024 Bulletin 2024/04**

(21) Application number: **22783925.5**

(22) Date of filing: **30.03.2022**

(51) International Patent Classification (IPC):
***G01R 31/382*** *(2019.01)*

(86) International application number:
**PCT/CN2022/084037**

(87) International publication number:
**WO 2022/213858 (13.10.2022 Gazette 2022/41)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **08.04.2021 CN 202110377624**

(71) Applicant: **Huawei Digital Power Technologies Co., Ltd.**
**Shenzhen, Guangdong 518043 (CN)**

(72) Inventors:
- **WU, Zhipeng**
  **Shenzhen, Guangdong 518043 (CN)**
- **LI, Lin**
  **Shenzhen, Guangdong 518043 (CN)**
- **LI, Wenbin**
  **Shenzhen, Guangdong 518043 (CN)**

(74) Representative: **Maiwald GmbH**
**Engineering**
**Elisenhof**
**Elisenstrasse 3**
**80335 München (DE)**

# (54) ENERGY STORAGE SYSTEM AND METHOD FOR CORRECTING STATE-OF-CHARGE VALUES THEREOF

(57) This application provides an energy storage system and a method for correcting a state of charge value thereof. The correction method includes: A battery management unit sends parameter information of each of energy storage units to a power scheduling unit; the power scheduling unit determines, based on accumulated running durations and accumulated power-off durations of the energy storage units, a target energy storage unit requiring correction; the power scheduling unit delivers a power scheduling instruction to the target energy storage unit, to control the target energy storage unit to receive charging power or output discharging power; and the battery management unit monitors a voltage and a state of charge value of target energy storage units; and corrects the state of charge value of the target energy storage unit when the voltage or the state of charge value of the target energy storage unit meets a specified condition. According to the correction method, the state of charge value can be corrected in a running process of the energy storage system, without shutting down the energy storage system. This improves availability and cost of the energy storage system, increases accuracy of the state of charge value, and further improves performance of the energy storage system.

103
Power scheduling unit
Direct current-to-direct current converter
104
Battery module
1011
101
...
FIG. 1

EP 4 310 524 A1

## Description

### CROSS-REFERENCE TO RELATED APPLICATIONS

This application claims priority to Chinese Patent Application No. 202110377624.5, filed with the China National Intellectual Property Administration on April 8, 2021 and entitled "ENERGY STORAGE SYSTEM AND METHOD FOR CORRECTING STATE OF CHARGE VALUE THEREOF", which is incorporated herein by reference in its entirety.

### TECHNICAL FIELD

This application relates to the field of energy technologies, and in particular, to an energy storage system and a method for correcting a state of charge value thereof.

### BACKGROUND

An electrochemical energy storage unit, represented by a lithium-ion battery, can store and release electrical energy between a power generation side, a power grid side, and a user side, to function as buffering, and has functions, such as peak shaving and valley filling, peak and frequency regulation, and cooperation with new energy for power generation and grid connection. A lithium-ion battery of a lithium-iron phosphate system is a lithium battery energy storage system that is most commonly used in power station energy storage because of high safety. To ensure a service life and safety of the electrochemical energy storage unit, power scheduling and current regulation need to be performed based on a state of charge (state of charge, SOC) of an energy storage unit. However, the SOC of the energy storage unit cannot be directly acquired and measured in real time by using a sensor, and can only be estimated based on other parameters of the energy storage unit. Accurate estimation of the SOC of the energy storage unit not only avoids overcharge, overdischarge, or the like, but also is important for achieving optimal performance of the energy storage unit.

In an energy storage system, a battery management unit estimates the SOC of the energy storage unit through ampere-hour accumulation calculation. Specifically, the battery management unit obtains an initial SOC value during startup, and performs accumulation or subtraction based on the initial SOC value according to parameters, such as a current and a sampling frequency, in a running process, to obtain an estimated SOC value. However, sampling has a deviation. A longer duration of the ampere-hour accumulation calculation indicates a larger accumulated deviation of the estimated SOC value.

In a related technology, the energy storage system needs to be first shut down, and the SOC of the energy storage unit in the energy storage system is corrected. In this case, the SOC of the energy storage unit cannot be corrected in a running process of the energy storage system, affecting availability and cost of the energy storage system.

### SUMMARY

Embodiments of this application provide an energy storage system and a method for correcting a state of charge value thereof, to correct a state of charge value of an energy storage unit in a running process of the energy storage system. This increases accuracy of the state of charge value of the energy storage unit, and further improves performance of the energy storage system.

According to a first aspect, an embodiment of this application provides an energy storage system. The energy storage system may include a plurality of energy storage units that are connected in parallel, a battery management unit, and a power scheduling unit. The battery management unit is configured to send parameter information of each of the energy storage units to the power scheduling unit. The parameter information includes an accumulated running duration and an accumulated power-off duration of the energy storage unit from a last correction time to a current time, and a current state of charge value of the energy storage unit. The power scheduling unit is configured to: determine, based on accumulated running durations and accumulated power-off durations of the energy storage units, a target energy storage unit requiring correction from the energy storage units, where an accumulated running duration of the target energy storage unit is greater than or equal to a first time threshold, or an accumulated power-off duration of the target energy storage unit is greater than or equal to a second time threshold; and deliver a power scheduling instruction to the target energy storage unit, to control the target energy storage unit to receive charging power or output discharging power. The battery management unit is further configured to: monitor a voltage and a state of charge value of the target energy storage unit; and correct the state of charge value of the target energy storage unit when the voltage or the state of charge value of the target energy storage unit meets a specified condition.

In the energy storage system provided in this embodiment of this application, the power scheduling unit may determine, based on the accumulated running durations and the accumulated power-off durations of the energy storage units, the target energy storage unit requiring correction. The target energy storage unit is an energy storage unit whose accumulated running duration is greater than or equal to a first time threshold, or an energy storage unit whose accumulated power-off duration is greater than or equal to a second time threshold. In other words, the target energy storage unit is an energy storage unit that runs for a long time or is left unused for a long time. These target energy storage units have been in a voltage plateau region for a long time. The power scheduling unit may deliver the power scheduling instruction to control the target energy storage unit to receive the charging power or output the discharging power. In this way, the target energy storage unit is departed from the voltage plateau region, and the energy storage units reach an end of charge or discharge at which a state of charge value can be corrected. When detecting that the voltage or the state of charge value of the target energy storage unit meets the specified condition, the battery management unit corrects the state of charge value of the target energy storage unit, to correct a state of charge value of the energy storage unit. In addition, in this embodiment of this application, the state of charge value may be corrected in a running process of the energy storage system, without shutting down the energy storage system. In this way, the state of charge value is corrected while availability and cost of the energy storage system are ensured, thereby increasing accuracy of the state of charge value of the energy storage unit, and further improving performance of the energy storage system.

In a possible implementation of this application, the energy storage system further includes a plurality of direct current-to-direct current converters that are respectively connected to the energy storage units. The power scheduling unit is further configured to deliver the power scheduling instruction to the battery management unit. The battery management unit is further configured to: control, according to the power scheduling instruction, the direct current-to-direct current converters to output the discharging power to the respectively connected energy storage units, or receive the charging power of the respectively connected energy storage units. This further helps control the target energy storage unit to be charged or discharged.

In a possible implementation of this application, the power scheduling unit is further configured to:

determine a correction manner of the target energy storage unit based on the state of charge value of the target energy storage unit, where if the state of charge value of the target energy storage unit is greater than or equal to a first threshold, the correction manner of the target energy storage unit is charging-based correction; or if the state of charge value of the target energy storage unit is less than or equal to a second threshold, the correction manner of the target energy storage unit is discharging-based correction.

When delivering the power scheduling instruction to the target energy storage unit, to control the target energy storage unit to receive the charging power or output the discharging power, the power scheduling unit is specifically configured to:

deliver the power scheduling instruction to the target energy storage unit, to control the target energy storage unit requiring charging-based correction to receive the charging power and control the target energy storage unit requiring discharging-based correction to output the discharging power.

In this embodiment of this application, before delivering the power scheduling instruction, the power scheduling unit first determines a correction manner of target energy storage units requiring correction, and subsequently delivers different power scheduling instructions based on different correction manners of the target energy storage units, to control the target energy storage unit requiring charging-based correction to receive the charging power and control the target energy storage unit requiring discharging-based correction to output the discharging power, thereby increasing a speed of a correction process. If the state of charge value of the target energy storage unit is greater than or equal to the first threshold, the state of charge value of the target energy storage unit is higher, and the target energy storage unit easily reaches an end of charge. Therefore, a charging-based correction manner is used to perform correction for the target energy storage unit, so that the target energy storage unit can be quickly departed from the voltage plateau region. If the state of charge value of the target energy storage unit is less than or equal to the second threshold, the state of charge value of the target energy storage unit is lower, and the target energy storage unit easily reaches an end of discharge. Therefore, a discharging-based correction manner is used to perform correction for the target energy storage unit, so that the target energy storage unit can be quickly departed from the voltage plateau region.

During specific implementation, the first threshold may range from 30% to 70%. For example, the first threshold may be 50%. The second threshold may range from 20% to 60%. For example, the second threshold may be 50%. Optionally, the first threshold may be equal to or not equal to the second threshold, and the first threshold may be greater than or equal to the second threshold. Alternatively, the first threshold may be less than the second threshold, and values of the first threshold and the second threshold may be determined based on an actual requirement.

In some embodiments, the first threshold may be greater than the second threshold. For example, the first threshold may be 60%, and the second threshold may be 40%. In this case, an energy storage unit whose state of charge value is greater than the first threshold uses a charging manner, and an energy storage unit whose state of charge value is less than the second threshold uses a discharging manner. An energy storage unit whose state of charge value is between the second threshold and the first threshold may not participate in correction, so that a quantity of target energy storage units requiring correction may be reduced. When an external load has a charging requirement or a discharging requirement subsequently, these energy storage units may meet the charging requirement or the discharging requirement of the external load.

Certainly, the first threshold may also be less than or equal to the second threshold. For example, the first threshold may be 40%, and the second threshold may be 50%. In this case, all energy storage units requiring correction may participate in correction. The energy storage unit whose state of charge value is between the first threshold and the second threshold may use charging-based correction or discharging-based correction.

In actual application, a voltage and a state of charge value of an energy storage unit are positively correlated. In a charging process, as the state of charge value increases, the voltage of the energy storage unit gradually increases. In a discharging process, as the state of charge value decreases, the voltage of the energy storage unit gradually decreases. Therefore, whether the energy storage unit reaches an end of charge or discharge may be determined by determining whether the voltage or the state of charge value of the energy storage unit meets the specified condition. Specifically, the specified condition may be the following: a voltage of the target energy storage unit requiring charging-based correction is greater than a first voltage threshold; or a state of charge value of the target energy storage unit requiring charging-based correction is greater than a third threshold; or a voltage of the target energy storage unit requiring discharging-based correction is less than a second voltage threshold; or a state of charge value of the target energy storage unit requiring discharging-based correction is less than a fourth threshold. The first voltage threshold ranges from 3.32 V to 3.4 V The second voltage threshold ranges from 2.5 V to 3.2 V The third threshold ranges from 90% to 96%. The fourth threshold ranges from 15% to 20%.

In a possible implementation of this application, the correction of the state of charge value of the target energy storage unit by the battery management unit meets the following formula:

$$SOC_w = SOC_{w-1} + A + K^*(U_1 - U_2)$$

$SOC_w$ represents a corrected state of charge value, w represents a quantity of sampling periods, $SOC_{w-1}$ represents a state of charge value in a previous sampling period, A represents an ampere-hour integral between two sampling periods, K represents a convergence coefficient, $U_1$ represents a current voltage of the target energy storage unit, $U_2$ represents a table lookup voltage, and the table lookup voltage is obtained based on $SOC_{w-1}$ and a correspondence between a state of charge value and a voltage.

In a running process, the battery management unit may perform accumulation or subtraction based on an initial state of charge value according to parameters, such as a current and a sampling frequency, to obtain an estimated state of charge value. Therefore, the battery management unit may monitor the state of charge value of each energy storage unit in real time. When detecting that the voltage or the state of charge value of the target energy storage unit meets the specified condition, the battery management unit may correct the current state of charge value based on the state of charge value $SOC_{w-1}$ in the previous sampling period, the ampere-hour integral A between the previous sampling period and a current sampling period, and a difference between the current voltage $U_1$ of the target energy storage unit and the table lookup voltage Uz, to obtain the corrected state of charge $SOC_w$.

In a possible implementation of this application, the battery management unit is further configured to: monitor whether the target energy storage unit requiring charging-based correction reaches a full-charge determining condition; and correct the state of charge value of the target energy storage unit that reaches the full-charge determining condition to a first state of charge value. For example, the first state of charge value may be 100%. Certainly, the first state of charge value may also be another value. This is not limited herein. The full-charge determining condition is that the voltage of the target energy storage unit is greater than or equal to a charge cut-off voltage; or the full-charge determining condition is that a current of the target energy storage unit is less than or equal to a specified current threshold.

Before the voltage of the target energy storage unit reaches the charge cut-off voltage, the target energy storage unit is charged in a constant current manner. After the voltage of the target energy storage unit reaches the charge cut-off voltage, the target energy storage unit continues to be charged in a constant voltage manner. In a process of charging at the constant voltage, a charging current gradually decreases. When the charging current is less than the specified current threshold, the target energy storage unit reaches a full-charge state. Therefore, the battery management unit may monitor the voltage and the current of the target energy storage unit to determine whether the target energy storage unit reaches the full-charge determining condition.

In other words, in this embodiment of this application, the power scheduling unit delivers the power scheduling instruction, to control the target energy storage unit requiring charging-based correction to receive the charging power. In a charging process, the battery management unit monitors the voltage, the current, and the state of charge value of each target energy storage unit. When it is detected that the voltage or the state of charge value of the target energy storage unit requiring charging-based correction meets the specified condition, that is, it is detected that the voltage of the target energy storage unit is greater than the first voltage threshold; or when the state of charge value of the target energy storage unit is greater than the third threshold, the battery management unit determines that the energy storage unit reaches an end of charge and corrects a current state of charge value of the target energy storage unit. In a process in which the target energy storage unit continues to be charged, when detecting that the target energy storage unit reaches the full-charge determining condition, that is, detecting that the voltage of the target energy storage unit is greater than or equal to the charge cut-off voltage or detecting that the current of the target energy storage unit is less than or equal to the specified current threshold, the battery management unit corrects the current state of charge value of the target energy storage unit to the first state of charge value, thereby further increasing accuracy of the state of charge value of the energy storage unit.

In a possible implementation of this application, the power scheduling unit is further configured to:

determine a priority sequence of target energy storage units requiring charging-based correction, where a larger state of charge value of the target energy storage unit indicates a higher priority; if at least two target energy storage units have a same state of charge value, a longer accumulated power-off duration of the target energy storage unit indicates a higher priority; if the at least two target energy storage units have a same accumulated power-off duration, a longer accumulated running duration of the target energy storage unit indicates a higher priority; and if the at least two target energy storage units have a same accumulated running duration, a larger physical address of the target energy storage unit indicates a higher priority;

determine a priority sequence of target energy storage units requiring discharging-based correction, where a smaller state of charge value of the target energy storage unit indicates a higher priority; if at least two target energy storage units have a same state of charge value, a longer accumulated power-off duration of the target energy storage unit indicates a higher priority; if the at least two target energy storage units have a same accumulated power-off duration, a longer accumulated running duration of the target energy storage unit indicates a higher priority; and if the at least two target energy storage units have a same accumulated running duration, a larger physical address of the target energy storage unit indicates a higher priority; and

allocate power to the target energy storage units based on the correction manner and the priority sequence of the target energy storage units.

In actual application, total power that can be scheduled by the power scheduling unit in the energy storage system is fixed. In addition, there may be a plurality of target energy storage units in the energy storage system. For a charging-based correction manner, a target energy storage unit with a larger state of charge value completes correction in a shorter time. If the charging power is preferentially allocated to a target energy storage unit with a smaller state of charge value, the target energy storage unit with the larger state of charge value may need to wait due to insufficient power allocation. Consequently, a total time of charging-based correction is relatively long. Therefore, in this embodiment of this application, for the charging-based correction manner, the power scheduling unit preferentially allocates the power to a target energy storage unit with a higher state of charge value. For a discharging-based correction manner, the power scheduling unit preferentially allocates the power to a target energy storage unit with a lower state of charge value. In this way, the power of the energy storage system can be properly allocated, and a correction speed of the energy storage system is accelerated.

For target energy storage units with a same state of charge value, the power scheduling unit may preferentially allocate the power to a target energy storage unit with a relatively long accumulated power-off duration. Compared with a target energy storage unit with a relatively short accumulated power-off duration, the target energy storage unit with the relatively long accumulated power-off duration has a greater deviation of a state of charge value and correction needs to be performed as soon as possible. Similarly, for target energy storage units with a same accumulated power-off duration, the power scheduling unit may preferentially allocate the power to a target energy storage unit with a relatively long accumulated running duration. This is also because the target energy storage unit with the relatively long accumulated running duration has a greater deviation of a state of charge value and correction needs to be performed as soon as possible. For target energy storage units with a same state of charge value, a same accumulated power-off duration, and a same accumulated running duration, the power scheduling unit may allocate the power in descending order of physical addresses. A physical address may identify a target energy storage unit. Therefore, the power scheduling unit allocates the power based on the physical address, and correction may be performed for the target energy storage unit in an orderly manner. Certainly, the power scheduling unit may also allocate the power in ascending order of physical addresses. This is not limited herein.

In a possible implementation of this application, to prevent a process of correcting the state of charge value of the target energy storage unit from affecting the charging requirement or the discharging requirement of the external load, before determining the correction manner of the target energy storage unit, the power scheduling unit is further configured to determine that an external load that is electrically connected to the energy storage system has no charging requirement or discharging requirement. In other words, only when it is determined that the external load has no charging requirement or discharging requirement, the power scheduling unit starts a related procedure of correction for the target energy storage unit, to avoid that a correction process affects energy supply of the energy storage system to the external load.

In a possible implementation of this application, the power scheduling unit is further configured to: in a process in which charging-based correction or discharging-based correction is performed for the target energy storage unit, determine whether the external load generates a charging requirement or a discharging requirement; and if it is determined that the external load generates the charging requirement, control the target energy storage unit requiring charging-based correction to continue to receive the charging power and control the target energy storage unit requiring discharging-based correction to stop outputting the discharging power; if it is determined that the external load generates the discharging requirement, control the target energy storage unit requiring discharging-based correction to continue to output the discharging power and control the target energy storage unit requiring charging-based correction to stop receiving the charging power; or if it is determined that the external load has no charging requirement or discharging requirement, control the target energy storage unit requiring charging-based correction to continue to receive the charging power and control the target energy storage unit requiring discharging-based correction to continue to output the discharging power.

In this embodiment of this application, in a process of charging-based correction or discharging-based correction, the power scheduling unit determines whether the external load generates the charging requirement or the discharging requirement. That is, the power scheduling unit can monitor the charging requirement or the discharging requirement of the external load. When detecting that the external load generates the charging requirement or the discharging requirement, the power scheduling unit provides related power for the external load to meet a requirement of the external load, to prevent a correction process of the target energy storage unit from affecting energy supply of the energy storage system to the external load. Specifically, when the external load generates the charging requirement, the charging-based correction process is consistent with the requirement of the external load. Therefore, the power scheduling unit may control the target energy storage unit requiring charging-based correction to continue to receive the charging power. However, the discharging-based correction process is inconsistent with the requirement of the external load. To avoid affecting the energy storage unit to supply energy to the external load, the power scheduling unit may control the target energy storage unit requiring discharging-based correction to stop outputting the discharging power, to preferentially meet the requirement of the external load. Similarly, when the external load generates the discharging requirement, to preferentially meet the requirement of the external load, the power scheduling unit may control the target energy storage unit requiring discharging-based correction to continue to output the discharging power and control the target energy storage unit requiring charging-based correction to stop receiving the charging power.

In a possible implementation of this application, the power scheduling unit is specifically configured to: if it is determined that the external load generates the charging requirement, control the target energy storage unit requiring charging-based correction to continue to receive the charging power and control the target energy storage unit whose state of charge value is less than a fifth threshold to stop outputting and inputting power. The fifth threshold is less than the second threshold. For example, the fifth threshold may be 20%. Certainly, the fifth threshold may also be another value less than the second threshold. This is not limited herein. When the external load generates the charging requirement, because the discharging-based correction process is inconsistent with the external requirement, the discharging-based correction process needs to be interrupted. The power scheduling unit controls target energy storage units whose state of charge values are less than the fifth threshold to stop outputting and inputting the power. That is, the target energy storage units whose state of charge values are lower do not participate in the charging process. In this way, discharging-based correction may continue to be performed for these target energy storage units in a subsequent correction process.

If it is determined that the external load generates the discharging requirement, the power scheduling unit controls the target energy storage unit requiring discharging-based correction to continue to output the discharging power and control the target energy storage unit whose state of charge value is greater than a sixth threshold to stop outputting and inputting power. The sixth threshold is greater than the first threshold. For example, the sixth threshold may be 80%. Certainly, the sixth threshold may also be another value greater than the first threshold. This is not limited herein. When the external load generates the discharging requirement, because the charging-based correction process is inconsistent with the external requirement, the charging-based correction process needs to be interrupted. The power scheduling unit controls target energy storage units whose state of charge values are greater than the sixth threshold to stop outputting and inputting the power. That is, the target energy storage units whose state of charge values are higher do not participate in the discharging process. In this way, charging-based correction may continue to be performed for these target energy storage units in a subsequent correction process.

In this embodiment of this application, a correction process of the energy storage system may be implemented in a plurality of manners. Details are as follows:

Implementation 1

In target energy storage units, if a correction manner of one part of the target energy storage units is charging-based correction and a correction manner of the other part of the target energy storage units is discharging-based correction, the power scheduling unit delivers the power scheduling instruction to each of the target energy storage units, to transmit, to the target energy storage unit requiring charging-based correction, the discharging power output by the target energy storage unit requiring discharging-based correction. In this way, energy between each target energy storage unit in the energy storage system is transferred, so that the target energy storage unit requiring correction may be departed from the voltage plateau region, providing a necessary condition for correcting the state of charge value of the target energy storage unit. In addition, the energy storage system can also complete a process of correcting the state of charge value of the target energy storage unit without a power requirement of the external load. Certainly, in a correction process of the energy storage system, the energy storage system may output power to the external load, or may receive power from the external load. In addition, in the correction process of the energy storage system, an energy storage unit requiring no correction may perform energy interaction with the external load, and a target energy storage unit for which correction is being performed may also perform energy interaction with the external load.

Implementation 2

If the correction manner of all the target energy storage units is charging-based correction, the power scheduling unit controls an energy storage unit requiring no correction to output the discharging power. In this way, energy between each energy storage unit in the energy storage system is transferred, so that a target energy storage unit requiring correction may be departed from the voltage plateau region, providing a necessary condition for correcting the state of charge value of the target energy storage unit. In addition, the energy storage system can also complete a process of correcting the state of charge value of the target energy storage unit without a power requirement of the external load.

Implementation 3

If the correction manner of all target energy storage units is discharging-based correction, the power scheduling unit controls an energy storage unit requiring no correction to receive the charging power. In this way, energy between each energy storage unit in the energy storage system is transferred, so that a target energy storage unit requiring correction may be departed from the voltage plateau region, providing a necessary condition for correcting the state of charge value of the target energy storage unit. In addition, the energy storage system can also complete a process of correcting the state of charge value of the target energy storage unit without a power requirement of the external load.

According to a second aspect, an embodiment of this application further provides a method for correcting a state of charge value of an energy storage system. The energy storage system includes a plurality of energy storage units that are connected in parallel, a battery management unit, and a power scheduling unit.

The foregoing method for correcting the state of charge value may include:

the battery management unit sends parameter information of each of the energy storage units to the power scheduling unit, where the parameter information includes an accumulated running duration and an accumulated power-off duration of the energy storage unit from a last correction time to a current time, and a current state of charge value of the energy storage unit;

the power scheduling unit determines, based on accumulated running durations and accumulated power-off durations of the energy storage units, a target energy storage unit requiring correction from the energy storage units, where an accumulated running duration of the target energy storage unit is greater than or equal to a first time threshold, or an accumulated power-off duration of the target energy storage unit is greater than or equal to a second time threshold;

the power scheduling unit delivers a power scheduling instruction to the target energy storage unit, to control the target energy storage unit to receive charging power or output discharging power; and

the battery management unit monitors a voltage and a state of charge value of target energy storage units; and corrects the state of charge value of the target energy storage unit when the voltage or the state of charge value of the target energy storage unit meets a specified condition.

In this embodiment of this application, for a specific implementation process of the foregoing method for correcting the state of charge value, refer to the implementation of the energy storage system. Details are not described again.

According to a third aspect, an embodiment of this application further provides a method for correcting a state of charge value of an energy storage system. The method is performed in a power scheduling unit in the energy storage system. The correction method may include:

receiving sent parameter information of each of energy storage units from a battery management unit, where the parameter information includes an accumulated running duration and an accumulated power-off duration of the energy storage unit from a last correction time to a current time, and a current state of charge value of the energy storage unit;

determining, based on accumulated running durations and accumulated power-off durations of the energy storage units, a target energy storage unit requiring correction from the energy storage units, where an accumulated running duration of the target energy storage unit is greater than or equal to a first time threshold, or an accumulated power-off duration of the target energy storage unit is greater than or equal to a second time threshold; and
delivering a power scheduling instruction to the target energy storage unit, to control the target energy storage unit to receive charging power or output discharging power, so that the battery management unit monitors a voltage and a state of charge value of target energy storage units; and correcting the state of charge value of the target energy storage unit when the voltage or the state of charge value of the target energy storage unit meets a specified condition.

In this embodiment of this application, for implementation of the correction method performed in the power scheduling unit, refer to the implementation of the energy storage system. Details are not described again.
According to a fourth aspect, an embodiment of this application further provides a method for correcting a state of charge value of an energy storage system. The method is performed in a battery management unit in the energy storage system. The correction method may include:

sending parameter information of each of energy storage units to a power scheduling unit, where the parameter information includes an accumulated running duration and an accumulated power-off duration of the energy storage unit from a last correction time to a current time, and a current state of charge value of the energy storage unit; and
monitoring a voltage and a state of charge value of target energy storage units; and correcting the state of charge value of the target energy storage unit when the voltage or the state of charge value of the target energy storage unit meets a specified condition.

In this embodiment of this application, for implementation of the correction method performed in the battery management unit, refer to the implementation of the energy storage system. Details are not described again.

**BRIEF DESCRIPTION OF DRAWINGS**

FIG. 1 is a schematic diagram of an architecture of an energy storage system according to an embodiment of this application;
FIG. 2 is a schematic diagram of another architecture of an energy storage system according to an embodiment of this application;
FIG. 3 is a schematic flowchart of a method for correcting a state of charge value according to an embodiment of this application;
FIG. 4A, FIG. 4B, and FIG. 4C are another schematic flowchart of a method for correcting a state of charge value according to an embodiment of this application;
FIG. 5 is a schematic diagram of an energy storage system in a correction process according to Implementation 1;
FIG. 6 is a schematic diagram of an energy storage system after correction;
FIG. 7 is a schematic diagram of an energy storage system in a correction process according to Implementation 2; and
FIG. 8 is a schematic diagram of an energy storage system in a correction process according to Implementation 3.

Reference numerals:

101: energy storage unit; 1011: battery module; 102: battery management unit; 103: power scheduling unit; 104: direct current-to-direct current converter; 105: external load.

**DESCRIPTION OF EMBODIMENTS**

In an energy storage system, a SOC and a voltage of an energy storage unit are positively correlated. In other words, a larger SOC indicates a larger voltage. A voltage correction method may be used to correct an estimated SOC value. However, the SOC and the voltage of the energy storage unit do not have a linear relationship. In a relationship curve between the SOC and the voltage, there is a long and smooth voltage plateau region. The voltage plateau region means that in a large range of about 25% to 85% for the SOC, a voltage change is very small. The relationship curve between the SOC and the voltage is very flat in the range. A same voltage in the voltage plateau region may correspond to a plurality of SOCs. Therefore, the estimated SOC value cannot be corrected in the voltage plateau region. Instead, the estimated SOC value needs to be corrected at an end of charge or discharge, that is, when the SOC is higher or lower.
However, in an actual application scenario, because a probability of occurrence of a charging scheduling instruction is basically the same as a probability of occurrence of a discharging scheduling instruction, it is rare that the energy storage unit is unidirectionally charged or discharged for a long time. In other words, the energy storage unit often runs in the voltage plateau region, and the energy storage unit cannot reach the end of charge or discharge. Consequently, the estimated SOC value of the energy storage unit cannot be corrected for a long time, SOC accuracy of the energy storage unit becomes increasingly low, and finally the SOC cannot provide reference, affecting power supply performance of the energy storage system.

In the related technology, after the energy storage system runs for a period of time, the energy storage system needs to be manually shut down, and the energy storage unit in the energy storage system is manually controlled to be fully charged or fully discharged once, to complete SOC correction of the energy storage unit. Then, the energy storage system is manually controlled to start up and run again. This correction manner requires that the energy storage system stops running, affects availability and cost of the energy storage system, and requires manual operations, and labor costs are relatively high.

In view of this, in a running process of the energy storage system, to correct the state of charge value of the energy storage unit, embodiments of this application provide an energy storage system and a method for correcting a state of charge value thereof.

To make the objectives, technical solutions, and advantages of this application clearer, the following further describes this application in detail with reference to the accompanying drawings.

It should be noted that, in this specification, similar reference numerals and letters in the following accompanying drawings represent similar items. Therefore, once an item is defined in an accompanying drawing, the item does not need to be further defined or interpreted in following accompanying drawings.

In descriptions of this application, it should be noted that orientation or location relationships indicated by terms "center", "above", "below", "left", "right", "vertical", "horizontal", "inner", "outer", and the like are orientation or location relationships based on the accompanying drawings, and are only intended for ease of describing this application and simplifying descriptions, rather than indicating or implying that an apparatus or element in question needs to have a specific orientation or needs to be constructed and operated in a specific orientation. Therefore, such terms cannot be construed as a limitation on this application. In addition, terms "first" and "second" are only used for a purpose of description, and shall not be understood as an indication or implication of relative importance.

In descriptions of this application, it should be noted that unless otherwise expressly specified and limited, terms "mount", "interconnect", and "connect" should be understood in a broad sense. For example, such terms may indicate a fixed connection, a detachable connection, or an integral connection; may indicate a mechanical connection or an electrical connection; and may indicate direct interconnection, indirect interconnection through an intermediate medium, or internal communication between two elements. A person of ordinary skill in the art may understand specific meanings of the foregoing terms in this application based on a specific situation.

The energy storage system in embodiments of this application may be electrically connected to various external loads, to supply electrical energy to the external loads. For example, the energy storage system may be electrically connected to a power grid, to supply charging power or discharging power to the power grid. For another example, the energy storage system may be electrically connected to a component in an electric vehicle, to supply electrical energy to the electric vehicle. Certainly, the energy storage system may also be configured to supply electrical energy to another external load, and examples are not numerated herein.

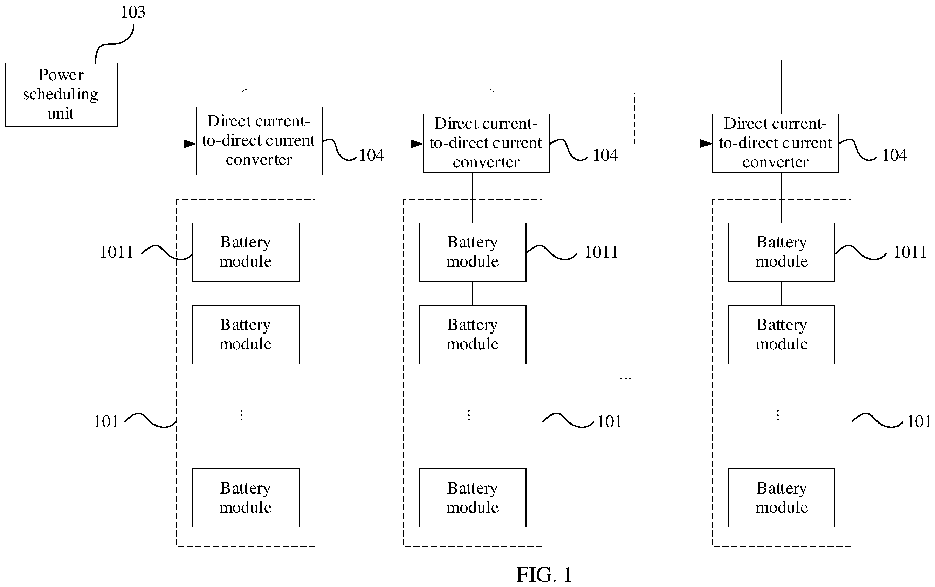

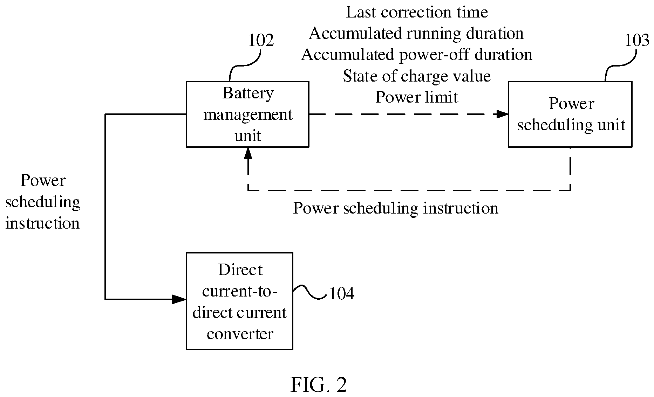

FIG. 1 is a schematic diagram of an architecture of an energy storage system according to an embodiment of this application. FIG. 2 is a schematic diagram of another architecture of an energy storage system according to an embodiment of this application. In FIG. 1 and FIG. 2, a solid line represents a control flow, and a dashed line represents a data flow. With reference to FIG. 1 and FIG. 2, the energy storage system may include a plurality of energy storage units 101 that are connected in parallel, a plurality of direct current-to-direct current converters 104 that are respectively connected to the energy storage units 101, a battery management unit 102, and a power scheduling unit 103. Each energy storage unit 101 may include a plurality of battery modules 1011 that are connected in series. To clearly show a structure of the energy storage system, in FIG. 1, an example in which the energy storage system includes three energy storage units 101 and each energy storage unit 101 includes three battery modules 1011 is used for illustration. During specific implementation, a quantity of energy storage units 101, and a quantity of battery modules 1011 in an energy storage unit 101 may be set based on an actual requirement. This is not limited herein.

Still with reference to FIG. 1 and FIG. 2, the battery management unit 102 may monitor parameter information of each of the energy storage units 101, and send the parameter information of each of the energy storage units 101 to the power scheduling unit 103. The parameter information may include parameters, such as a voltage, a temperature, a current, a state of charge value, and a power limit of the energy storage unit. The battery management unit 102 may further perform fault diagnosis based on the parameter information of the energy storage unit 101. The power scheduling unit 103 may deliver a power scheduling instruction based on the parameter information sent by the battery management unit 102, to control the energy storage unit 101 to receive charging power or output discharging power. Specifically, the power scheduling unit 103 sends the power scheduling instruction to the battery management unit 102, and the battery management unit 102 controls, according to the power scheduling instruction, the direct current-to-direct current converters 104 to input and output energy, to control the energy storage unit 101 to receive the charging power or output the discharging power. Optionally, the battery management unit 102 may include a battery monitoring unit and a battery control unit. The battery monitoring unit may be configured to detect the parameter information of each of the energy storage units 101. The battery control unit may be configured to transmit the power scheduling instruction. Usually, the battery module 1011 may include a battery and a monitoring unit board. To help monitor parameter information of the battery in the battery module 1011, the battery monitoring unit may be integrated into the monitoring unit board.

The method for correcting a state of charge value in embodiments of this application is mainly used to correct a state of charge value of an energy storage unit that is often in a voltage plateau region, and mainly includes the following two scenarios: Scenario 1: The energy storage unit runs for a long time. Because a probability of occurrence of a charging scheduling instruction is basically the same as a probability of occurrence of a discharging scheduling instruction, it is rare that the energy storage unit is unidirectionally charged or discharged for a long time. Therefore, the energy storage unit that runs for a long time is usually in the voltage plateau region, and an error of a state of charge value obtained through ampere-hour accumulation calculation is higher. Scenario 2: The energy storage unit is left unused for a long time, so that the energy storage unit is in the voltage plateau region for a long time and the energy storage unit has a self-discharge phenomenon. As a result, a deviation between an estimated state of charge value and an actual state of charge value is higher. According to the correction method provided in embodiments of this application, the energy storage unit in the two scenarios can be departed from the voltage plateau region, to correct the state of charge value.

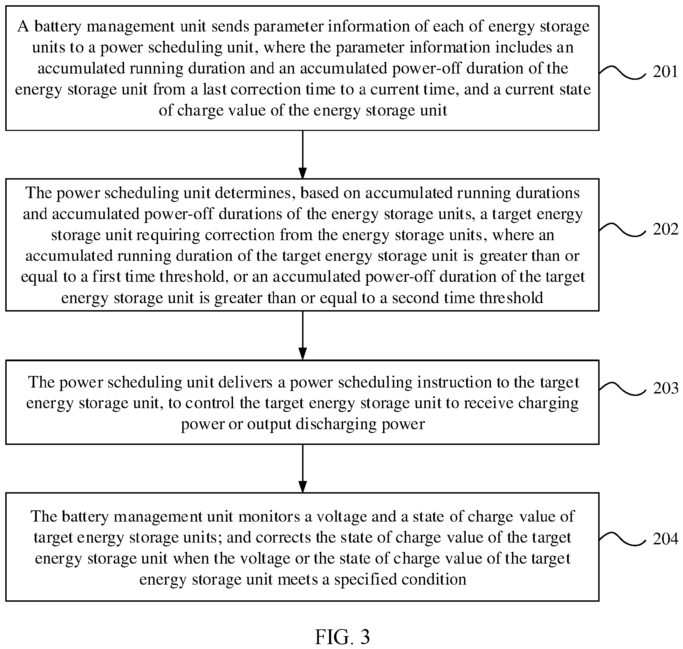

FIG. 3 is a schematic flowchart of a method for correcting a state of charge value according to an embodiment of this application. As shown in FIG. 3, the method for correcting a state of charge value of an energy storage system in this embodiment of this application may include the following steps.

S201: A battery management unit sends parameter information of each of energy storage units to a power scheduling unit, where the parameter information includes an accumulated running duration and an accumulated power-off duration of the energy storage unit from a last correction time to a current time, and a current state of charge value of the energy storage unit.

S202: The power scheduling unit determines, based on accumulated running durations and accumulated power-off durations of the energy storage units, a target energy storage unit requiring correction from the energy storage units, where an accumulated running duration of the target energy storage unit is greater than or equal to a first time threshold, or an accumulated power-off duration of the target energy storage unit is greater than or equal to a second time threshold.

S203: The power scheduling unit delivers a power scheduling instruction to the target energy storage unit, to control the target energy storage unit to receive charging power or output discharging power.

S204: The battery management unit monitors a voltage and a state of charge value of target energy storage units; and corrects the state of charge value of the target energy storage unit when the voltage or the state of charge value of the target energy storage unit meets a specified condition.

According to the method for correcting the state of charge value provided in this embodiment of this application, the power scheduling unit may determine, based on the accumulated running durations and the accumulated power-off durations of the energy storage units, the target energy storage unit requiring correction. The target energy storage unit is an energy storage unit whose accumulated running duration is greater than or equal to a first time threshold, or an energy storage unit whose accumulated power-off duration is greater than or equal to a second time threshold. In other words, the target energy storage unit is an energy storage unit that runs for a long time or is left unused for a long time. These target energy storage units have been in a voltage plateau region for a long time. The power scheduling unit may deliver the power scheduling instruction to control the target energy storage unit to receive the charging power or output the discharging power. In this way, the target energy storage unit is departed from the voltage plateau region, and the energy storage units reach an end of charge or discharge at which a state of charge value can be corrected. When detecting that the voltage or the state of charge value of the target energy storage unit meets the specified condition, the battery management unit corrects the state of charge value of the target energy storage unit, to correct a state of charge value of the energy storage unit. In addition, according to the correction method in this embodiment of this application, the state of charge value may be corrected in a running process of the energy storage system, without shutting down the energy storage system. In this way, the state of charge value is corrected while availability and cost of the energy storage system are ensured, thereby increasing accuracy of the state of charge value of the energy storage unit, and further improving performance of the energy storage system.

In the foregoing step S201, with reference to FIG. 2, the battery management unit 102 may send parameter information, such as a last correction time, an accumulated running duration and an accumulated power-off duration from the last correction time to a current time, a state of charge value, and a power limit, to the power scheduling unit 103. The last correction time is a last correction time of the state of charge value of the energy storage unit. In addition, last correction may be correction in any manner. For example, the last correction may be manual correction, or the last correction may be a correction method in this application. A manner of the last correction is not limited herein. The battery management unit 102 may estimate the state of charge value of the energy storage unit through ampere-hour accumulation calculation. Specifically, the battery management unit 102 obtains an initial state of charge value of each energy storage unit during startup. In a running process, the battery management unit 102 may perform accumulation or subtraction based on the initial state of charge value according to parameters, such as a current and a sampling frequency, to obtain an estimated state of charge value. Therefore, the battery management unit 102 may monitor the state of charge value of each energy storage unit in real time.

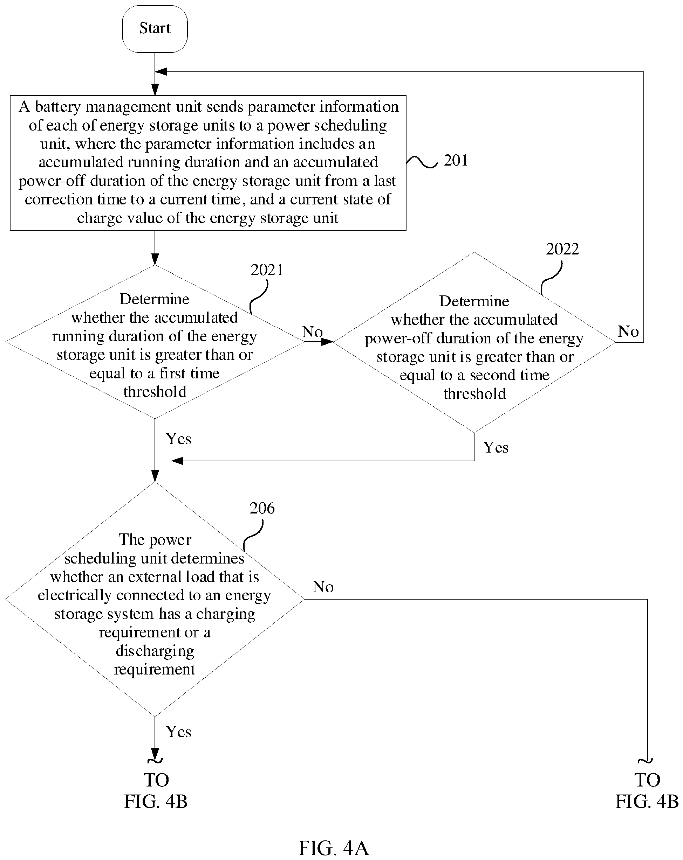

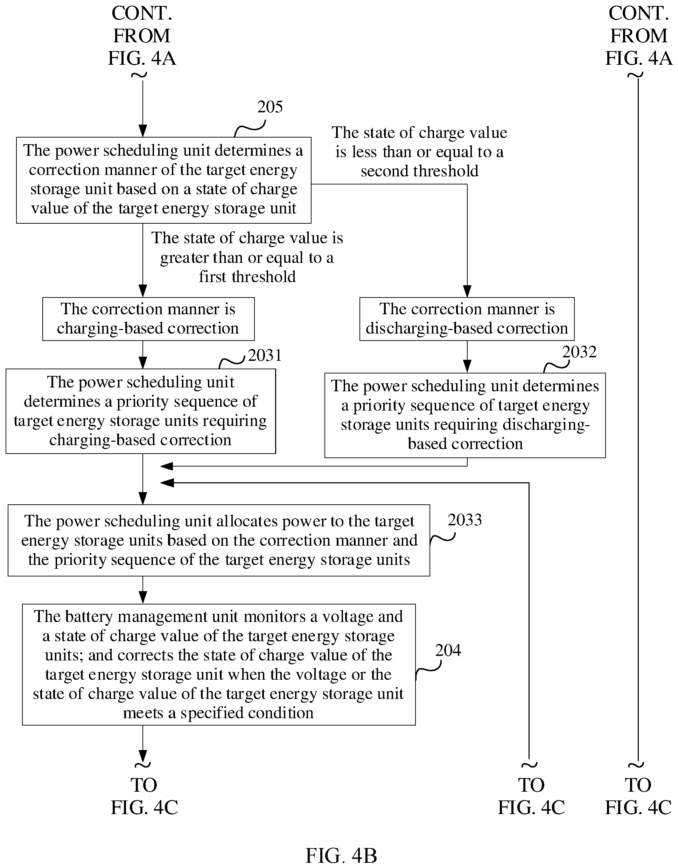

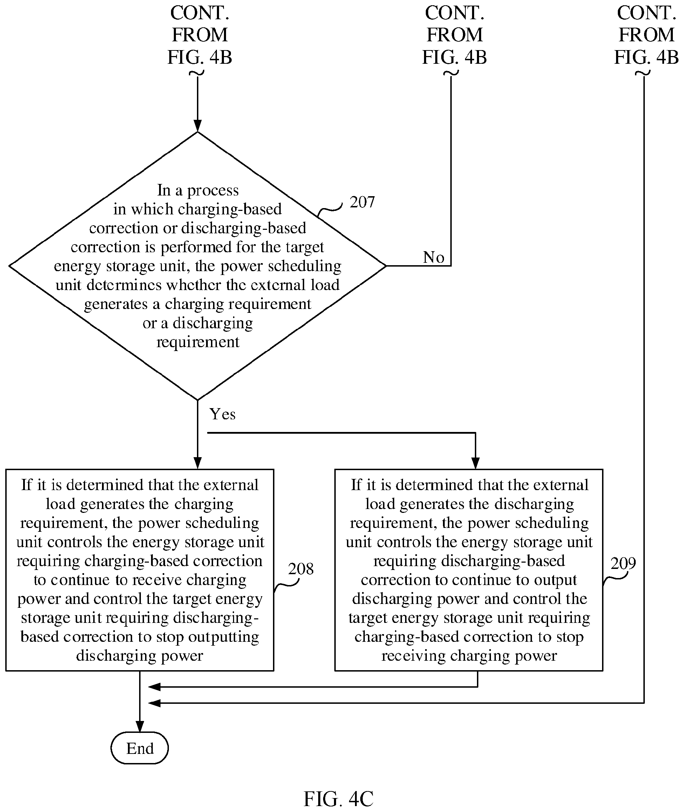

FIG. 4A, FIG. 4B, and FIG. 4C are another schematic flowchart of a method for correcting a state of charge value according to an embodiment of this application. As shown in FIG. 4A, the foregoing step S202 may include the following steps.

S2021: Determine whether the accumulated running duration of the energy storage unit is greater than or equal to the first time threshold; and if the accumulated running duration of the energy storage unit is greater than or equal to the first time threshold, perform step S203; or if the accumulated running duration of the energy storage unit is not greater than or equal to the first time threshold, perform step S2022.

S2022: Determine whether the accumulated power-off duration of the energy storage unit is greater than or equal to the second time threshold; and if the accumulated power-off duration of the energy storage unit is greater than or equal to the second time threshold, perform step S203; or if the accumulated power-off duration of the energy storage unit is not greater than or equal to the second time threshold, return to step S201.

In the foregoing step S2021, it may be determined whether the energy storage unit runs for a long time. In the foregoing step S2022, it may be determined whether the energy storage unit is left unused for a long time. Therefore, in the foregoing step S202, it may be determined which energy storage units are in the voltage platform area for a long time, that is, which energy storage units require correction. In addition, in this embodiment of this application, for example, whether the accumulated running duration of the energy storage unit is greater than or equal to the first time threshold is first determined, and whether the accumulated power-off duration of the energy storage unit is greater than or equal to the second time threshold is then determined. During specific implementation, alternatively, whether the accumulated power-off duration of the energy storage unit is greater than or equal to the second time threshold may be first determined, and whether the accumulated running duration of the energy storage unit is greater than or equal to the first time threshold may be then determined. That is, a sequence of the foregoing step S2021 and the foregoing step S2022 may be exchanged, which is not limited herein.

In the foregoing step S203, the power scheduling unit delivers the power scheduling instruction to control the target energy storage unit to receive the charging power or output the discharging power and control the target energy storage unit to be charged or discharged. In this way, the energy storage unit is departed from the voltage plateau region, and reaches an end of charge or discharge at which a state of charge value can be corrected. In the foregoing step S204, the battery management unit detects whether the voltage or the state of charge value of the energy storage units requiring correction reaches the specified condition, to monitor whether the energy storage unit is departed from the voltage plateau region and correct the state of charge value of the energy storage unit that is departed from the voltage plateau region, to correct the state of charge value in a running process of the energy storage system.

In some implementations of this application, as shown in FIG. 2, the foregoing step S203 may specifically include: The power scheduling unit 103 delivers the power scheduling instruction to the battery management unit 102; and the battery management unit 102 controls, according to the power scheduling instruction, the direct current-to-direct current converters 104 to output the discharging power to the respectively connected target energy storage units, or to receive the charging power of the respectively connected target energy storage units, to control the target energy storage unit to be charged or discharged.

Optionally, as shown in FIG. 4B, after the foregoing step S202 is performed and before the foregoing step S203 is performed, the foregoing correction method provided in this embodiment of this application may further include the following step.

S205: The power scheduling unit determines a correction manner of the target energy storage unit based on the state of charge value of the target energy storage unit, where if the state of charge value of the target energy storage unit is greater than or equal to a first threshold, the correction manner of the energy storage unit is charging-based correction; or if the state of charge value of the target energy storage unit is less than or equal to a second threshold, the correction manner of the energy storage unit is discharging-based correction.

The foregoing step S203 may include the following.

The power scheduling unit delivers the power scheduling instruction to the target energy storage unit, to control the target energy storage unit requiring charging-based correction to receive the charging power and control the target energy storage unit requiring discharging-based correction to output the discharging power.

In this embodiment of this application, before delivering the power scheduling instruction, the power scheduling unit first determines a correction manner of target energy storage units requiring correction, and subsequently delivers different power scheduling instructions based on different correction manners of the target energy storage units, to control the target energy storage unit requiring charging-based correction to receive the charging power and control the target energy storage unit requiring discharging-based correction to output the discharging power, thereby increasing a speed of a correction process. If the state of charge value of the target energy storage unit is greater than or equal to the first threshold, the state of charge value of the target energy storage unit is higher, and the target energy storage unit easily reaches an end of charge. Therefore, a charging-based correction manner is used to perform correction for the target energy storage unit, so that the target energy storage unit can be quickly departed from the voltage plateau region. If the state of charge value of the target energy storage unit is less than or equal to the second threshold, the state of charge value of the target energy storage unit is lower, and the target energy storage unit easily reaches an end of discharge. Therefore, a discharging-based correction manner is used to perform correction for the target energy storage unit, so that the target energy storage unit can be quickly departed from the voltage plateau region.

During specific implementation, according to the foregoing correction method provided in this embodiment of this application, the first threshold may range from 30% to 70%. For example, the first threshold may be 50%. The second threshold may range from 20% to 60%. For example, the second threshold may be 50%. Optionally, the first threshold may be equal to or not equal to the second threshold, and the first threshold may be greater than or equal to the second threshold. Alternatively, the first threshold may be less than the second threshold, and values of the first threshold and the second threshold may be determined based on an actual requirement.

In some embodiments, the first threshold may be greater than the second threshold. For example, the first threshold may be 60%, and the second threshold may be 40%. In this case, an energy storage unit whose state of charge value is greater than the first threshold uses a charging manner, and an energy storage unit whose state of charge value is less than the second threshold uses a discharging manner. An energy storage unit whose state of charge value is between the second threshold and the first threshold may not participate in correction, so that a quantity of target energy storage units requiring correction may be reduced. When an external load has a charging requirement or a discharging requirement subsequently, these energy storage units may meet the charging requirement or the discharging requirement of the external load.

Certainly, the first threshold may also be less than or equal to the second threshold. For example, the first threshold may be 40%, and the second threshold may be 50%. In this case, all energy storage units requiring correction may participate in correction. The energy storage unit whose state of charge value is between the first threshold and the second threshold may use charging-based correction or discharging-based correction.

In actual application, a voltage and a state of charge value of an energy storage unit are positively correlated. In a charging process, as the state of charge value increases, the voltage of the energy storage unit gradually increases. In a discharging process, as the state of charge value decreases, the voltage of the energy storage unit gradually decreases. Therefore, whether the energy storage unit reaches an end of charge or discharge may be determined by determining whether the voltage or the state of charge value of the energy storage unit meets the specified condition. Specifically, the specified condition may be the following: a voltage of the target energy storage unit requiring charging-based correction is greater than a first voltage threshold; or a state of charge value of the target energy storage unit requiring charging-based correction is greater than a third threshold; or a voltage of the target energy storage unit requiring discharging-based correction is less than a second voltage threshold; or a state of charge value of the target energy storage unit requiring discharging-based correction is less than a fourth threshold. The first voltage threshold ranges from 3.32 V to 3.4 V The second voltage threshold ranges from 2.5 V to 3.2 V The third threshold ranges from 90% to 96%. The fourth threshold ranges from 15% to 20%.

According to the foregoing correction method provided in this embodiment of this application, in the foregoing step S204, that the battery management unit corrects the state of charge value of the target energy storage unit meets the following formula:

$$SOC_w = SOC_{w-1} + A + K^*(U_1 - U_2)$$

$SOC_w$ represents a corrected state of charge value, w represents a quantity of sampling periods, $SOC_{w-1}$ represents a state of charge value in a previous sampling period, A represents an ampere-hour integral between two sampling periods, K represents a convergence coefficient, $U_1$ represents a current voltage of the target energy storage unit, $U_2$ represents a table lookup voltage, and the table lookup voltage $U_2$ is obtained based on $SOC_{w-1}$ and a correspondence between a state of charge value and a voltage.

In a running process, the battery management unit may perform accumulation or subtraction based on an initial state of charge value according to parameters, such as a current and a sampling frequency, to obtain an estimated state of charge value. Therefore, the battery management unit may monitor the state of charge value of each energy storage unit in real time. When detecting that the voltage or the state of charge value of the target energy storage unit meets the specified condition, the battery management unit may correct the current state of charge value based on the state of charge value $SOC_{w-1}$ in the previous sampling period, the ampere-hour integral A between the previous sampling period and a current sampling period, and a difference between the current voltage $U_1$ of the target energy storage unit and the table lookup voltage Uz, to obtain the corrected state of charge $SOC_w$.

The ampere-hour integral A between the previous sampling period and the current sampling period is a product of a charging current (or a discharging current) and a time interval between the two sampling periods.

The table lookup voltage $U_2$ may be obtained based on $SOC_{w-1}$ and the correspondence between a state of charge value and a voltage. For ease of query, the correspondence between a state of charge value and a voltage may be represented in a form of a list, so that the table lookup voltage $U_2$ may be obtained by querying in the list based on the state of charge value $SOC_{w-1}$. Certainly, the correspondence between a state of charge value and a voltage may also be represented in another form, which is not limited herein. To describe a specific process of determining the table lookup voltage $U_2$, a list of a relationship between a voltage and a state of charge value that requires discharging-based correction is used as an example for description. As shown in Table 1, a horizontal table header in Table 1 is a voltage, and a vertical table header is a discharge rate. The discharge rate is a ratio of a current in a discharging process of an energy storage unit. In a table lookup process, the table lookup voltage $U_2$ may be obtained based on a current discharge rate and the state of charge $SOC_{w-1}$. For example, if the state of charge $SOC_{w-1}$ is 6% and the current discharge rate is 0.5C, it may be obtained that the table lookup voltage $U_2$ is 3.096. The process of determining the table lookup voltage $U_2$ in the charging process is similar to that in the discharging process, and is not described herein.

**Table 1 Correspondence between a state of charge value and a voltage**

| SOC / Voltage / Rate | 0% | 2% | 4% | 6% | 8% | 10% | 12% | 14% |
|---|---|---|---|---|---|---|---|---|
| 0.1C | 2.5 | 2.9221 | 3.0592 | 3.1399 | 3.1615 | 3.1671 | 3.1716 | 3.1846 |
| 0.2C | 2.5 | 2.9085 | 3.0478 | 3.1263 | 3.148 | 3.1552 | 3.1608 | 3.1737 |
| 0.3C | 2.5 | 2.8979 | 3.038 | 3.1157 | 3.1373 | 3.1455 | 3.152 | 3.1644 |
| 0.5C | 2.5 | 2.8803 | 3.0206 | 3.096 | 3.1185 | 3.1283 | 3.136 | 3.1474 |
| 0.6C | 2.5 | 2.8766 | 3.0157 | 3.0921 | 3.1143 | 3.124 | 3.1314 | 3.1422 |
| 0.8C | 2.5 | 2.865 | 3.0019 | 3.0768 | 3.0997 | 3.11 | 3.118 | 3.1277 |
| 1.0C | 2.5 | 2.853 | 2.9869 | 3.0607 | 3.084 | 3.0948 | 3.1031 | 3.1122 |

Further, the foregoing correction method provided in this embodiment of this application may further include: The battery management unit monitors whether the target energy storage unit requiring charging-based correction reaches a full-charge determining condition; and corrects the state of charge value of the target energy storage unit that reaches the full-charge determining condition to a first state of charge value. For example, the first state of charge value may be 100%. Certainly, the first state of charge value may also be another value. This is not limited herein. The full-charge determining condition is that the voltage of the target energy storage unit is greater than or equal to a charge cut-off voltage; or the full-charge determining condition is that a current of the target energy storage unit is less than or equal to a specified current threshold.

Before the voltage of the target energy storage unit reaches the charge cut-off voltage, the target energy storage unit is charged in a constant current manner. After the voltage of the target energy storage unit reaches the charge cut-off voltage, the target energy storage unit continues to be charged in a constant voltage manner. In a process of charging at the constant voltage, a charging current gradually decreases. When the charging current is less than the specified current threshold, the target energy storage unit reaches a full-charge state. Therefore, the battery management unit may monitor the voltage and the current of the target energy storage unit to determine whether the target energy storage unit reaches the full-charge determining condition.

In other words, in this embodiment of this application, the power scheduling unit delivers the power scheduling instruction, to control the target energy storage unit requiring charging-based correction to receive the charging power. In a charging process, the battery management unit monitors the voltage, the current, and the state of charge value of each target energy storage unit. When it is detected that the voltage or the state of charge value of the target energy storage unit requiring charging-based correction meets the specified condition, that is, it is detected that the voltage of the target energy storage unit is greater than the first voltage threshold; or when the state of charge value of the target energy storage unit is greater than the third threshold, the battery management unit determines that the energy storage unit reaches an end of charge and corrects a current state of charge value of the target energy storage unit. In a process in which the target energy storage unit continues to be charged, when detecting that the target energy storage unit reaches the full-charge determining condition, that is, detecting that the voltage of the target energy storage unit is greater than or equal to the charge cut-off voltage or detecting that the current of the target energy storage unit is less than or equal to the specified current threshold, the battery management unit corrects the current state of charge value of the target energy storage unit to the first state of charge value, thereby further increasing accuracy of the state of charge value of the energy storage unit.

In a discharging process of the target energy storage unit, the battery management unit also monitors the voltage, the current, and the state of charge value of each target energy storage unit. When it is detected that the voltage or the state of charge value of the target energy storage unit requiring discharging-based correction meets the specified condition, that is, it is detected that the voltage of the target energy storage unit is less than the second voltage threshold; or when the state of charge value of the target energy storage unit is less than the fourth threshold, the battery management unit determines that the target energy storage unit reaches an end of discharge and corrects a current state of charge value of the target energy storage unit. The target energy storage unit may continue to be discharged after reaching the end of discharge. Different from the charging-based correction process, the battery management unit does not need to correct a minimum state of charge value when the target energy storage unit reaches a fully discharged state. This is because the minimum state of charge value may be specified differently in different application scenarios. The voltage of the energy storage unit is related to the temperature. Compared with a room temperature environment, when the energy storage unit is discharged in a lower-temperature environment, the voltage of the energy storage unit decreases more quickly. In this case, when the energy storage unit reaches a discharge cut-off voltage in the lower-temperature environment, the energy storage unit has reached the fully discharged state. That is, the energy storage unit cannot be discharged anymore, but the energy storage unit may still have some electricity. For example, when the temperature is about -10°C, the voltage of the energy storage unit is about 2.5 V and the voltage is less than a full-discharge cut-off voltage. That is, the energy storage unit has reached the fully discharged state. However, when the temperature rises to a room temperature (about 25°C), the voltage of the energy storage unit may rise to about 3.1 V and the voltage is greater than the full-discharge cut-off voltage, so that the energy storage unit can still continue to be discharged at the room temperature. That is, in the lower-temperature environment, a part of electricity of the energy storage unit is sealed. In some application scenarios, for example, if the energy storage system works in the low-temperature environment for a long time, it is required that the state of charge value of the energy storage unit is corrected to a minimum value when the voltage of the energy storage unit reaches the full-discharge cut-off voltage. However, in some other application scenarios, for example, if the energy storage unit works in the room temperature environment for a long time and occasionally works in the lower-temperature environment, it is required that the state of charge value of the energy storage unit is corrected to a minimum value when the energy storage unit reaches the fully discharged state at the room temperature. In addition, in this embodiment of this application, when detecting that the target energy storage unit reaches the end of charge or discharge, the battery management unit may correct the state of charge value of the target energy storage unit. Moreover, when detecting that the target energy storage unit reaches the full-charge determining condition, the battery management unit may also correct the state of charge value of the target energy storage unit. That is, even if the minimum state of charge value is not corrected, accuracy of the state of charge value of the energy storage unit can be relatively high.

Optionally, according to the foregoing correction method provided in this embodiment of this application, as shown in FIG. 4B, the foregoing step S203 may include the following steps.

S2031: The power scheduling unit determines a priority sequence of target energy storage units requiring charging-based correction, where a larger state of charge value of the target energy storage unit indicates a higher priority; if at least two target energy storage units have a same state of charge value, a longer accumulated power-off duration of the target energy storage unit indicates a higher priority; if the at least two target energy storage units have a same accumulated power-off duration, a longer accumulated running duration of the target energy storage unit indicates a higher priority; and if the at least two target energy storage units have a same accumulated running duration, a larger physical address of the target energy storage unit indicates a higher priority; that is, the priority sequence of the target energy storage units requiring charging-based correction is in descending order of the state of charge value, the accumulated power-off duration, the accumulated running duration, and the physical address.

S2032: The power scheduling unit determines a priority sequence of target energy storage units requiring discharging-based correction, where a smaller state of charge value of the target energy storage unit indicates a higher priority; if at least two target energy storage units have a same state of charge value, a longer accumulated power-off duration of the target energy storage unit indicates a higher priority; if the at least two target energy storage units have a same accumulated power-off duration, a longer accumulated running duration of the target energy storage unit indicates a higher priority; and if the at least two target energy storage units have a same accumulated running duration, a larger physical address of the target energy storage unit indicates a higher priority; that is, the priority sequence of the target energy storage units requiring discharging-based correction is in ascending order of the state of charge value, and in descending order of the accumulated power-off duration, the accumulated running duration, and the physical address.

S2033: The power scheduling unit allocates power to the target energy storage units based on the correction manner and the priority sequence of the target energy storage units.

In actual application, total power that can be scheduled by the power scheduling unit in the energy storage system is fixed. In addition, there may be a plurality of target energy storage units in the energy storage system. For a charging-based correction manner, a target energy storage unit with a larger state of charge value completes correction in a shorter time. If the charging power is preferentially allocated to a target energy storage unit with a smaller state of charge value, the target energy storage unit with the larger state of charge value may need to wait due to insufficient power allocation. Consequently, a total time of charging-based correction is relatively long. Therefore, in this embodiment of this application, for the charging-based correction manner, the power scheduling unit preferentially allocates the power to a target energy storage unit with a higher state of charge value. For a discharging-based correction manner, the power scheduling unit preferentially allocates the power to a target energy storage unit with a lower state of charge value. In this way, the power of the energy storage system can be properly allocated, and a correction speed of the energy storage system is accelerated.

For target energy storage units with a same state of charge value, the power scheduling unit may preferentially allocate the power to a target energy storage unit with a relatively long accumulated power-off duration. Compared with a target energy storage unit with a relatively short accumulated power-off duration, the target energy storage unit with the relatively long accumulated power-off duration has a greater deviation of a state of charge value and correction needs to be performed as soon as possible. Similarly, for target energy storage units with a same accumulated power-off duration, the power scheduling unit may preferentially allocate the power to a target energy storage unit with a relatively long accumulated running duration. This is also because the target energy storage unit with the relatively long accumulated running duration has a greater deviation of a state of charge value and correction needs to be performed as soon as possible. For target energy storage units with a same state of charge value, a same accumulated power-off duration, and a same accumulated running duration, the power scheduling unit may allocate the power in descending order of physical addresses. A physical address may identify a target energy storage unit. Therefore, the power scheduling unit allocates the power based on the physical address, and correction may be performed for the target energy storage unit in an orderly manner. Certainly, the power scheduling unit may also allocate the power in ascending order of physical addresses. This is not limited herein.

During specific implementation, to prevent a process of correcting the state of charge value of the target energy storage unit from affecting the charging requirement or the discharging requirement of the external load, in this embodiment of this application, before the foregoing step S205 is performed, the method may further include the following step.

S206: The power scheduling unit determines whether the external load that is electrically connected to the energy storage system has the charging requirement or the discharging requirement; and if yes, that is, when it is determined that the external load has no charging requirement or discharging requirement, perform the foregoing step S205.

In other words, only when it is determined that the external load has no charging requirement or discharging requirement, the power scheduling unit starts a related procedure of correction for the target energy storage unit, to avoid that a correction process affects energy supply of the energy storage system to the external load.

In some embodiments of this application, as shown in FIG. 3 and FIG. 4C, the foregoing correction method may further include the following steps.

S207: In a process in which charging-based correction or discharging-based correction is performed for the target energy storage unit, the power scheduling unit determines whether the external load generates the charging requirement or the discharging requirement; and if the power scheduling unit determines that the external load has no charging requirement or discharging requirement, return to the foregoing step S203.

S208: If it is determined that the external load generates the charging requirement, the power scheduling unit controls the target energy storage unit requiring charging-based correction to continue to receive the charging power and control the energy storage unit requiring discharging-based correction to stop outputting the discharging power.

S209: If it is determined that the external load generates the discharging requirement, the power scheduling unit controls the target energy storage unit requiring discharging-based correction to continue to output the discharging power and control the energy storage unit requiring charging-based correction to stop receiving the charging power.

In this embodiment of this application, in a process of charging-based correction or discharging-based correction, the power scheduling unit determines whether the external load generates the charging requirement or the discharging requirement. That is, the power scheduling unit can monitor the charging requirement or the discharging requirement of the external load. When detecting that the external load generates the charging requirement or the discharging requirement, the power scheduling unit provides related power for the external load to meet a requirement of the external load, to prevent a correction process of the target energy storage unit from affecting energy supply of the energy storage system to the external load. Specifically, when the external load generates the charging requirement, the charging-based correction process is consistent with the requirement of the external load. Therefore, the power scheduling unit may control the target energy storage unit requiring charging-based correction to continue to receive the charging power. However, the discharging-based correction process is inconsistent with the requirement of the external load. To avoid affecting the energy storage unit to supply energy to the external load, the power scheduling unit may control the target energy storage unit requiring discharging-based correction to stop outputting the discharging power, to preferentially meet the requirement of the external load. Similarly, when the external load generates the discharging requirement, to preferentially meet the requirement of the external load, the power scheduling unit may control the target energy storage unit requiring discharging-based correction to continue to output the discharging power and control the target energy storage unit requiring charging-based correction to stop receiving the charging power.

Optionally, according to the foregoing correction method provided in this embodiment of this application, the foregoing step S208 may specifically include the following:

if it is determined that the external load generates the charging requirement, the power scheduling unit controls the target energy storage unit requiring charging-based correction to continue to receive the charging power and controls the target energy storage unit whose state of charge value is less than a fifth threshold to stop outputting and inputting power. The fifth threshold is less than the second threshold. For example, the fifth threshold may be 20%. Certainly, the fifth threshold may also be another value less than the second threshold. This is not limited herein. When the external load generates the charging requirement, because the discharging-based correction process is inconsistent with the external requirement, the discharging-based correction process needs to be interrupted. The power scheduling unit controls target energy storage units whose state of charge values are less than the fifth threshold to stop outputting and inputting the power. That is, the target energy storage units whose state of charge values are lower do not participate in the charging process. In this way, discharging-based correction may continue to be performed for these target energy storage units in a subsequent correction process.

For example, the foregoing step S209 may specifically include the following:

if it is determined that the external load generates the discharging requirement, the power scheduling unit controls the target energy storage unit requiring discharging-based correction to continue to output the discharging power and controls the target energy storage unit whose state of charge value is greater than a sixth threshold to stop outputting and inputting power. The sixth threshold is greater than the first threshold. For example, the sixth threshold may be 80%. Certainly, the sixth threshold may also be another value greater than the first threshold. This is not limited herein. When the external load generates the discharging requirement, because the charging-based correction process is inconsistent with the external requirement, the charging-based correction process needs to be interrupted. The power scheduling unit controls target energy storage units whose state of charge values are greater than the sixth threshold to stop outputting and inputting the power. That is, the target energy storage units whose state of charge values are higher do not participate in the discharging process. In this way, charging-based correction may continue to be performed for these target energy storage units in a subsequent correction process.

In this embodiment of this application, a correction process of the energy storage system may be implemented in a plurality of manners. The following describes in detail energy transfer processes in different implementations with reference to the accompanying drawings.

Implementation 1

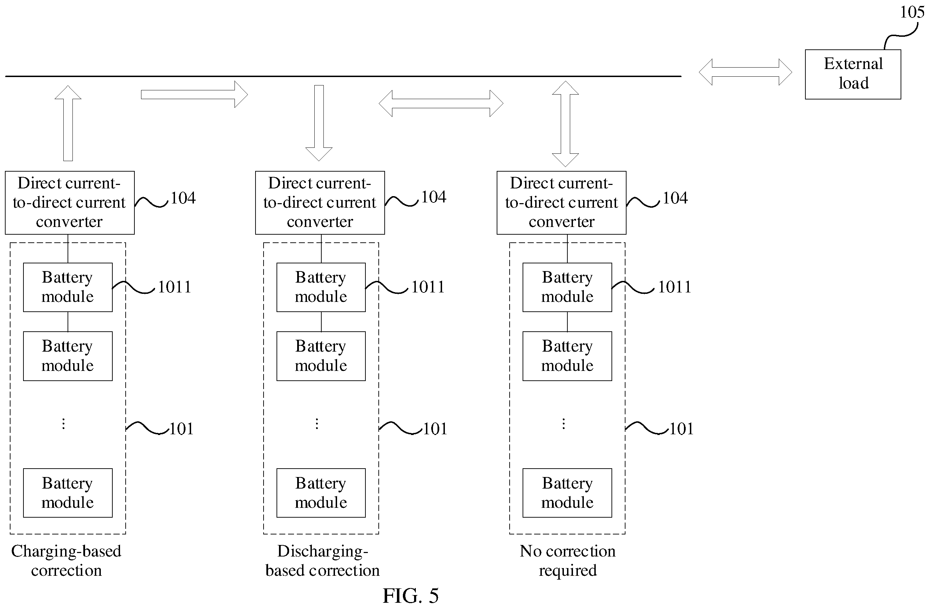

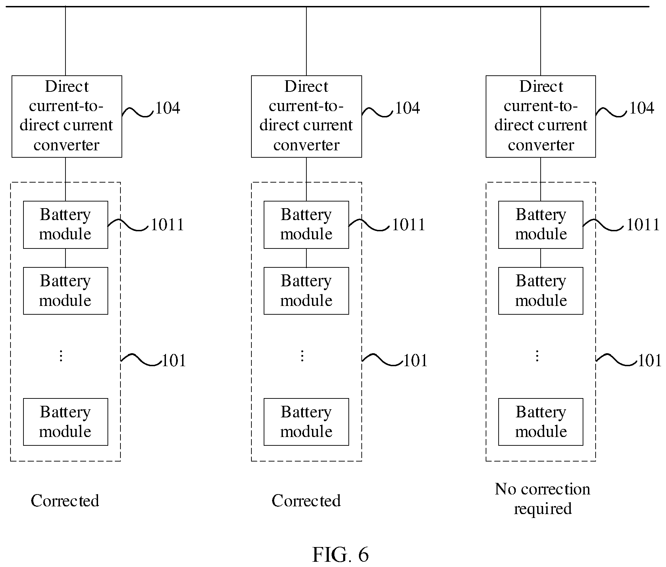

FIG. 5 is a schematic diagram of an energy storage system in a correction process according to Implementation 1. FIG. 6 is a schematic diagram of an energy storage system after correction. As shown in FIG. 5, an arrow represents a power flow. In target energy storage units 101 requiring correction, if a correction manner of one part of the target energy storage units 101 is charging-based correction, for example, the correction manner of the target energy storage unit 101 on the left in FIG. 5 is charging-based correction, and a correction manner of the other part of the target energy storage units 101 is discharging-based correction, for example, the correction manner of the target energy storage unit 101 in the middle in FIG. 5 is discharging-based correction, the power scheduling unit delivers the power scheduling instruction, to transmit, to the target energy storage unit 101 requiring charging-based correction, the discharging power output by the target energy storage unit 101 requiring discharging-based correction. In this way, energy between each target energy storage unit 101 in the energy storage system is transferred, so that the target energy storage unit 101 requiring correction may be departed from the voltage plateau region, providing a necessary condition for correcting the state of charge value of the target energy storage unit 101. In addition, the energy storage system can also complete a process of correcting the state of charge value of the target energy storage unit 101 without a power requirement of an external load 105. Certainly, in a correction process of the energy storage system, the energy storage system may output power to the external load 105, or may receive power from the external load 105. In addition, in the correction process of the energy storage system, an energy storage unit requiring no correction may perform energy interaction with the external load 105, and a target energy storage unit 101 for which correction is being performed may also perform energy interaction with the external load 105. For a specific interaction manner, refer to the foregoing step S208 and step S209.

Details are not described herein again. As shown in FIG. 6, according to the correction method in this embodiment of this application, all the target energy storage units 101 requiring correction in the energy storage system have completed the correction.

Implementation 2

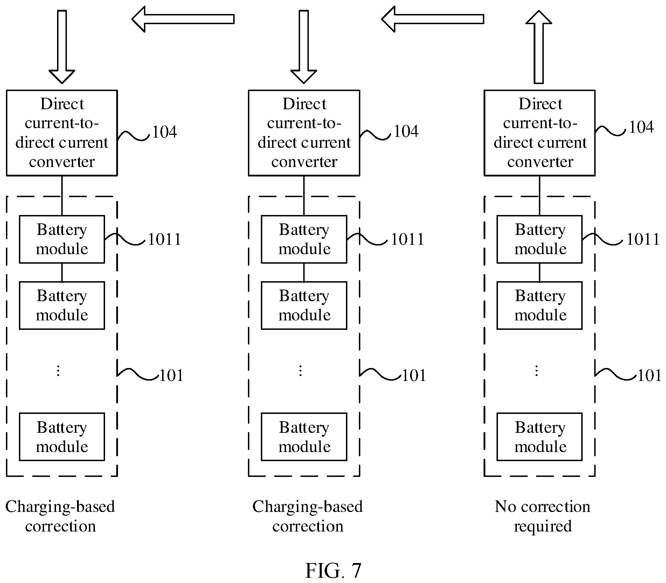

FIG. 7 is a schematic diagram of an energy storage system in a correction process according to Implementation 2. As shown in FIG. 7, if the correction manner of all the target energy storage units 101 requiring correction is charging-based correction, the power scheduling unit controls an energy storage unit 101 requiring no correction to output discharging power. For example, the correction manner of both the two target energy storage units 101 located on the left and in the middle in FIG. 7 is charging-based correction, and the discharging power output by the energy storage unit 101, which requires no correction and is on the right, is transmitted to the two target energy storage units 101 located on the left and in the middle. In this way, energy between each energy storage unit 101 in the energy storage system is transferred, so that the target energy storage unit 101 requiring correction may be departed from the voltage plateau region, providing a necessary condition for correcting the state of charge value of the target energy storage unit 101. In addition, the energy storage system can also complete a process of correcting the state of charge value of the target energy storage unit 101 without a power requirement of an external load. In this embodiment of this application, the energy storage system that completes the correction shown in FIG. 6 can also be obtained in the correction process of Implementation 2.

Implementation 3

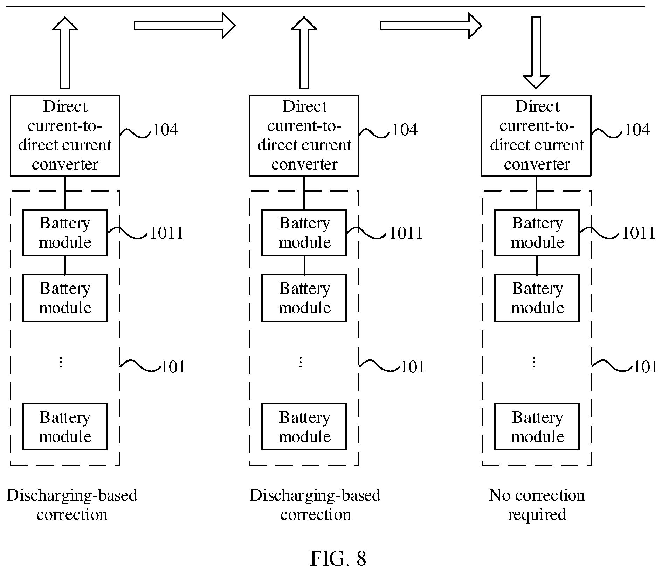

FIG. 8 is a schematic diagram of an energy storage system in a correction process according to Implementation 3. As shown in FIG. 8, if the correction manner of all the target energy storage units 101 requiring correction is discharging-based correction, the power scheduling unit controls an energy storage unit 101 requiring no correction to receive the charging power. For example, the correction manner of both the two target energy storage units 101 located on the left and in the middle in FIG. 8 is discharging-based correction, and the discharging power output by the two target energy storage units 101 is transmitted to the energy storage unit 101 that is located on the right and requires no correction. In this way, energy between each energy storage unit 101 in the energy storage system is transferred, so that the target energy storage unit 101 requiring correction may be departed from the voltage plateau region, providing a necessary condition for correcting the state of charge value of the target energy storage unit 101. In addition, the energy storage system can also complete a process of correcting the state of charge value of the target energy storage unit 101 without a power requirement of an external load. In this embodiment of this application, the energy storage system that completes the correction shown in FIG. 6 can also be obtained in the correction process of Implementation 3.

Based on a same technical concept, an embodiment of this application further provides an energy storage system. For example, as shown in FIG. 1 and FIG. 2, the energy storage system may include a plurality of energy storage units 101 that are connected in parallel, a battery management unit 102, and a power scheduling unit 103.

The battery management unit 102 is configured to send parameter information of each of the energy storage units 101 to the power scheduling unit 103. The parameter information includes an accumulated running duration and an accumulated power-off duration of the energy storage unit 101 from a last correction time to a current time, and a current state of charge value of the energy storage unit 101.

The power scheduling unit 103 is configured to: determine, based on accumulated running durations and accumulated power-off durations of the energy storage units 101, a target energy storage unit 101 requiring correction from the energy storage units, where an accumulated running duration of the target energy storage unit 101 is greater than or equal to a first time threshold, or an accumulated power-off duration of the target energy storage unit 101 is greater than or equal to a second time threshold; and deliver a power scheduling instruction to the target energy storage unit 101, to control the target energy storage unit 101 to receive charging power or output discharging power.

The battery management unit 102 is further configured to: monitor a voltage and a state of charge value of the target energy storage unit 101; and correct the state of charge value of the target energy storage unit 101 when the voltage or the state of charge value of the target energy storage unit 101 meets a specified condition.

In the energy storage system provided in this embodiment of this application, the power scheduling unit may determine a target energy storage unit based on the accumulated running durations and the accumulated power-off durations of the energy storage units. The target energy storage unit is an energy storage unit whose accumulated running duration is greater than or equal to a first time threshold, or an energy storage unit whose accumulated power-off duration is greater than or equal to a second time threshold. In other words, the target energy storage unit is an energy storage unit that runs for a long time or is left unused for a long time. These target energy storage units have been in a voltage plateau region for a long time. The power scheduling unit may deliver the power scheduling instruction to control the target energy storage unit to receive the charging power or output the discharging power. In this way, the target energy storage unit is departed from the voltage plateau region, and the energy storage units reach an end of charge or discharge at which a state of charge value can be corrected. When detecting that the voltage or the state of charge value of the target energy storage unit meets the specified condition, the battery management unit corrects the state of charge value of the target energy storage unit, to correct a state of charge value of the energy storage unit. In addition, according to the correction method in this embodiment of this application, the state of charge value may be corrected in a running process of the energy storage system, without shutting down the energy storage system. In this way, the state of charge value is corrected while availability and cost of the energy storage system are ensured, thereby increasing accuracy of the state of charge value of the energy storage unit, and further improving performance of the energy storage system.

In some implementations of this application, the power scheduling unit is further configured to:

determine a correction manner of the target energy storage unit based on the state of charge value of the target energy storage unit, where if the state of charge value of the target energy storage unit is greater than or equal to a first threshold, the correction manner of the target energy storage unit is charging-based correction; or if the state of charge value of the target energy storage unit is less than or equal to a second threshold, the correction manner of the target energy storage unit is discharging-based correction; and

when delivering the power scheduling instruction to the target energy storage unit, to control the target energy storage unit to receive the charging power or output the discharging power, the power scheduling unit is specifically configured to:

deliver the power scheduling instruction to the target energy storage unit, to control the target energy storage unit requiring charging-based correction to receive the charging power and control the target energy storage unit requiring discharging-based correction to output the discharging power.

During specific implementation, according to the foregoing correction method provided in this embodiment of this application, the specified condition is the following: a voltage of the target energy storage unit requiring charging-based correction is greater than a first voltage threshold; or a state of charge value of the target energy storage unit requiring charging-based correction is greater than a third threshold; or a voltage of the target energy storage unit requiring discharging-based correction is less than a second voltage threshold; or a state of charge value of the target energy storage unit requiring discharging-based correction is less than a fourth threshold.

The first voltage threshold ranges from 3.32 V to 3.4 V The second voltage threshold ranges from 2.5 V to 3.2 V The third threshold ranges from 90% to 96%. The fourth threshold ranges from 15% to 20%.

According to the foregoing correction method provided in this embodiment of this application, the correction of the state of charge value of the target energy storage unit by the battery management unit meets the following formula:

$$SOC_w = SOC_{w-1} + A + K*(U_1 - U_2)$$

$SOC_w$ represents a corrected state of charge value, w represents a quantity of sampling periods, $SOC_{w-1}$ represents a state of charge value in a previous sampling period, A represents an ampere-hour integral between two sampling periods, K represents a convergence coefficient, $U_1$ represents a current voltage of the target energy storage unit, $U_2$ represents a table lookup voltage, and the table lookup voltage is obtained based on $SOC_{w-1}$ and a correspondence between a state of charge value and a voltage.

Further, according to the foregoing correction method provided in this embodiment of this application, the battery management unit is further configured to: monitor whether the target energy storage unit requiring charging-based correction reaches a full-charge determining condition; and correct the state of charge value of the target energy storage unit that reaches the full-charge determining condition to a first state of charge value.

The full-charge determining condition is that the voltage of the target energy storage unit is greater than or equal to a charge cut-off voltage; or the full-charge determining condition is that a current of the target energy storage unit is less than or equal to a specified current threshold.

During specific implementation, to prevent a process of correcting the state of charge value of the target energy storage unit, before determining the correction manner of the target energy storage unit, the power scheduling unit is further configured to: determine that an external load that is electrically connected to the energy storage system has no charging requirement or discharging requirement.

In some embodiments of this application, the power scheduling unit is further configured to:

in a process in which charging-based correction or discharging-based correction is performed for the target energy storage unit, determine whether the external load generates a charging requirement or a discharging requirement; and

if it is determined that the external load generates the charging requirement, control the target energy storage unit requiring charging-based correction to continue to receive the charging power and control the target energy storage unit requiring discharging-based correction to stop outputting the discharging power;
if it is determined that the external load generates the discharging requirement, control the target energy storage unit requiring discharging-based correction to continue to output the discharging power and control the target energy storage unit requiring charging-based correction to stop receiving the charging power; or
if it is determined that the external load has no charging requirement or discharging requirement, control the target energy storage unit requiring charging-based correction to continue to receive the charging power and control the target energy storage unit requiring discharging-based correction to continue to output the discharging power.

Optionally, in the energy storage system provided in this embodiment of this application, the power scheduling unit is specifically configured to:

if it is determined that the external load generates the charging requirement, control the target energy storage unit requiring charging-based correction to continue to receive the charging power and control the target energy storage unit whose state of charge value is less than a fifth threshold to stop outputting and inputting power, where the fifth threshold is less than the second threshold; or
if it is determined that the external load generates the discharging requirement, control the target energy storage unit requiring discharging-based correction to continue to output the discharging power and control the target energy storage unit whose state of charge value is greater than a sixth threshold to stop outputting and inputting power, where the sixth threshold is greater than the first threshold.

In a possible implementation, when delivering the power scheduling instruction to the target energy storage unit, to control the target energy storage unit requiring charging-based correction to receive the charging power and control the target energy storage unit requiring discharging-based correction to output the discharging power, the power scheduling unit is specifically configured to:

in target energy storage units, if a correction manner of one part of the target energy storage units is charging-based correction and a correction manner of the other part of the target energy storage units is discharging-based correction, deliver the power scheduling instruction to each of the target energy storage units, to transmit, to the target energy storage unit requiring charging-based correction, the discharging power output by the target energy storage unit requiring discharging-based correction;
if the correction manner of all the target energy storage units is charging-based correction, control an energy storage unit requiring no correction to output the discharging power; or
if the correction manner of all the target energy storage units is discharging-based correction, control an energy storage unit requiring no correction to receive the charging power.

Optionally, in the energy storage system provided in this embodiment of this application, the power scheduling unit is specifically configured to:

determine a priority sequence of target energy storage units requiring charging-based correction, where a larger state of charge value of the target energy storage unit indicates a higher priority; if at least two target energy storage units have a same state of charge value, a longer accumulated power-off duration of the target energy storage unit indicates a higher priority; if the at least two target energy storage units have a same accumulated power-off duration, a longer accumulated running duration of the target energy storage unit indicates a higher priority; and if the at least two target energy storage units have a same accumulated running duration, a larger physical address of the target energy storage unit indicates a higher priority;
determine a priority sequence of target energy storage units requiring discharging-based correction, where a smaller state of charge value of the target energy storage unit indicates a higher priority; if at least two target energy storage units have a same state of charge value, a longer accumulated power-off duration of the target energy storage unit indicates a higher priority; if the at least two target energy storage units have a same accumulated power-off duration, a longer accumulated running duration of the target energy storage unit indicates a higher priority; and if the at least two target energy storage units have a same accumulated running duration, a larger physical address of the target energy storage unit indicates a higher priority; and
allocate power to the target energy storage units based on the correction manner and the priority sequence of the target energy storage units.

Optionally, in the energy storage system provided in this embodiment of this application, the first threshold ranges from 30% to 70%, and the second threshold ranges from 20% to 60%.

In a possible implementation, as shown in FIG. 1 and FIG. 2, the energy storage system in this embodiment of this application may further include a plurality of direct current-to-direct current converters 104 that are respectively connected to the energy storage units 101.

The power scheduling unit 103 is further configured to deliver the power scheduling instruction to the battery management unit 102.

The battery management unit 102 is further configured to: control, according to the power scheduling instruction, the direct current-to-direct current converters 104 to output the discharging power to the respectively connected energy storage units 101, or receive the charging power of the respectively connected energy storage units 101.

Based on a same technical concept, an embodiment of this application further provides a method for correcting a state of charge value of an energy storage system. The method is performed in a power scheduling unit in the energy storage system. The correction method may include:

receiving sent parameter information of each of energy storage units from a battery management unit, where the parameter information includes an accumulated running duration and an accumulated power-off duration of the energy storage unit from a last correction time to a current time, and a current state of charge value of the energy storage unit;
determining, based on accumulated running durations and accumulated power-off durations of the energy storage units, a target energy storage unit requiring correction from the energy storage units, where an accumulated running duration of the target energy storage unit is greater than or equal to a first time threshold, or an accumulated power-off duration of the target energy storage unit is greater than or equal to a second time threshold; and
delivering a power scheduling instruction to the target energy storage unit, to control the target energy storage unit to receive charging power or output discharging power, so that the battery management unit monitors a voltage and a state of charge value of target energy storage units; and correcting the state of charge value of the target energy storage unit when the voltage or the state of charge value of the target energy storage unit meets a specified condition.

In this embodiment of this application, for implementation of the correction method performed in the power scheduling unit, refer to any one of the correction methods shown in FIG. 3 to FIG. 8. Details are not described again.

Based on a same technical concept, an embodiment of this application further provides a method for correcting a state of charge value of an energy storage system. The method is performed in a battery management unit in the energy storage system. The correction method may include:

sending parameter information of each of energy storage units to a power scheduling unit, where the parameter information includes an accumulated running duration and an accumulated power-off duration of the energy storage unit from a last correction time to a current time, and a current state of charge value of the energy storage unit; and
monitoring a voltage and a state of charge value of target energy storage units; and correcting the state of charge value of target energy storage unit when the voltage or the state of charge value of the target energy storage unit meets a specified condition.

In this embodiment of this application, for implementation of the correction method performed in the battery management unit, refer to any one of the correction methods shown in FIG. 3 to FIG. 8. Details are not described again.

The foregoing descriptions are only specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

**1.** An energy storage system, comprising a plurality of energy storage units that are connected in parallel, a battery management unit, and a power scheduling unit, wherein

the battery management unit is configured to send parameter information of each of the energy storage units to the power scheduling unit, wherein the parameter information comprises an accumulated running duration and an accumulated power-off duration of the energy storage unit from a last correction time to a current time, and a current state of charge value of the energy storage unit;
the power scheduling unit is configured to: determine, based on accumulated running durations and accumulated power-off durations of the energy storage units, a target energy storage unit requiring correction from the energy storage units, wherein an accumulated running duration of the target energy storage unit is greater than or equal to a first time threshold, or an accumulated power-off duration of the target energy storage unit is greater than or equal to a second time threshold; and deliver a power scheduling instruction to the target energy storage unit, to control the target energy storage unit to receive charging power or output discharging power; and
the battery management unit is further configured to: monitor a voltage and a state of charge value of the target energy storage unit; and correct the state of charge value of the target energy storage unit when the voltage or the state of charge value of the target energy storage unit meets a specified condition.

**2.** The energy storage system according to claim 1, wherein the power scheduling unit is further configured to:

determine a correction manner of the target energy storage unit based on the state of charge value of the target energy storage unit, wherein if the state of charge value of the target energy storage unit is greater than or equal to a first threshold, the correction manner of the target energy storage unit is charging-based correction; or if the state of charge value of the target energy storage unit is less than or equal to a second threshold, the correction manner of the target energy storage unit is discharging-based correction; and
when delivering the power scheduling instruction to the target energy storage unit, to control the target energy storage unit to receive the charging power or output the discharging power, the power scheduling unit is specifically configured to:
deliver the power scheduling instruction to the target energy storage unit, to control the target energy storage unit requiring charging-based correction to receive the charging power and control the target energy storage unit requiring discharging-based correction to output the discharging power.

**3.** The energy storage system according to claim 2, wherein the specified condition is the following:

a voltage of the target energy storage unit requiring charging-based correction is greater than a first voltage threshold; or
a state of charge value of the target energy storage unit requiring charging-based correction is greater than a third threshold; or
a voltage of the target energy storage unit requiring discharging-based correction is less than a second voltage threshold; or
a state of charge value of the target energy storage unit requiring discharging-based correction is less than a fourth threshold, wherein
the first voltage threshold ranges from 3.32 V to 3.4 V, the second voltage threshold ranges from 2.5 V to 3.2 V, the third threshold ranges from 90% to 96%, and the fourth threshold ranges from 15% to 20%.

**4.** The energy storage system according to any one of claims 1 to 3, wherein the correction of the state of charge value of the target energy storage unit by the battery management unit meets the following formula:

$$SOC_w = SOC_{w-1} + A + K*(U_1 - U_2),$$

wherein
$SOC_w$ represents a corrected state of charge value, w represents a quantity of sampling periods, $SOC_{w-1}$ represents a state of charge value in a previous sampling period, A represents an ampere-hour integral between two sampling periods, K represents a convergence coefficient, $U_1$ represents a current voltage of the target energy storage unit, $U_2$ represents a table lookup voltage, and the table lookup voltage is obtained based on $SOC_{w-1}$ and a correspondence between a state of charge value and a voltage.

**5.** The energy storage system according to claim 2 or 3, wherein the battery management unit is further configured to: monitor whether the target energy storage unit requiring charging-based correction reaches a full-charge determining condition; and correct the state of charge value of the target energy storage unit that reaches the full-charge determining condition to a first state of charge value, wherein
the full-charge determining condition is that the voltage of the target energy storage unit is greater than or equal to a charge cut-off voltage; or the full-charge determining condition is that a current of the target energy storage unit is less than or equal to a specified current threshold.

**6.** The energy storage system according to claim 2, wherein before determining the correction manner of the target energy storage unit, the power scheduling unit is further configured to:
determine that an external load that is electrically connected to the energy storage system has no charging requirement or discharging requirement.

7. The energy storage system according to claim 6, wherein the power scheduling unit is further configured to:

in a process in which charging-based correction or discharging-based correction is performed for the target energy storage unit, determine whether the external load generates a charging requirement or a discharging requirement; and
if it is determined that the external load generates the charging requirement, control the target energy storage unit requiring charging-based correction to continue to receive the charging power and control the target energy storage unit requiring discharging-based correction to stop outputting the discharging power;
if it is determined that the external load generates the discharging requirement, control the target energy storage unit requiring discharging-based correction to continue to output the discharging power and control the target energy storage unit requiring charging-based correction to stop receiving the charging power; or
if it is determined that the external load has no charging requirement or discharging requirement, control the target energy storage unit requiring charging-based correction to continue to receive the charging power and control the target energy storage unit requiring discharging-based correction to continue to output the discharging power.

8. The energy storage system according to claim 7, wherein the power scheduling unit is specifically configured to:

if it is determined that the external load generates the charging requirement, control the target energy storage unit requiring charging-based correction to continue to receive the charging power and control the target energy storage unit whose state of charge value is less than a fifth threshold to stop outputting and inputting power, wherein the fifth threshold is less than the second threshold; or
if it is determined that the external load generates the discharging requirement, control the target energy storage unit requiring discharging-based correction to continue to output the discharging power and control the target energy storage unit whose state of charge value is greater than a sixth threshold to stop outputting and inputting power, wherein the sixth threshold is greater than the first threshold.

9. The energy storage system according to claim 2, wherein when delivering the power scheduling instruction to the target energy storage unit, to control the target energy storage unit requiring charging-based correction to receive the charging power and control the target energy storage unit requiring discharging-based correction to output the discharging power, the power scheduling unit is specifically configured to:

in target energy storage units, if a correction manner of one part of the target energy storage units is charging-based correction and a correction manner of the other part of the target energy storage units is discharging-based correction, deliver the power scheduling instruction to each of the target energy storage units, to transmit, to the target energy storage unit requiring charging-based correction, the discharging power output by the target energy storage unit requiring discharging-based correction;
if the correction manner of all the target energy storage units is charging-based correction, control an energy storage unit requiring no correction to output the discharging power; or
if the correction manner of all the target energy storage units is discharging-based correction, control an energy storage unit requiring no correction to receive the charging power.

10. The energy storage system according to claim 2, wherein the power scheduling unit is further configured to:

determine a priority sequence of target energy storage units requiring charging-based correction, wherein a larger state of charge value of the target energy storage unit indicates a higher priority; if at least two target energy storage units have a same state of charge value, a longer accumulated power-off duration of the target energy storage unit indicates a higher priority; if the at least two target energy storage units have a same accumulated power-off duration, a longer accumulated running duration of the target energy storage unit indicates a higher priority; and if the at least two target energy storage units have a same accumulated running duration, a larger physical address of the target energy storage unit indicates a higher priority;
determine a priority sequence of target energy storage units requiring discharging-based correction, wherein a smaller state of charge value of the target energy storage unit indicates a higher priority; if at least two target energy storage units have a same state of charge value, a longer accumulated power-off duration of the target energy storage unit indicates a higher priority; if the at least two target energy storage units have a same accumulated power-off duration, a longer accumulated running duration of the target energy storage unit indicates a higher priority; and if the at least two target energy storage units have a same accumulated running duration, a larger physical address of the target energy storage unit indicates a higher priority; and
allocate power to the target energy storage units based on the correction manner and the priority sequence of the target energy storage units.

**11.** The energy storage system according to any one of claims 2 and 3 and 5 to 10, wherein the first threshold ranges from 30% to 70%, and the second threshold ranges from 20% to 60%.

**12.** The energy storage system according to any one of claims 1 to 11, further comprising a plurality of direct current-to-direct current converters that are respectively connected to the energy storage units, wherein

the power scheduling unit is further configured to deliver the power scheduling instruction to the battery management unit; and
the battery management unit is further configured to: control, according to the power scheduling instruction, the direct current-to-direct current converters to output the discharging power to the respectively connected energy storage units, or receive the charging power of the respectively connected energy storage units.

**13.** A method for correcting a state of charge value of an energy storage system, wherein the energy storage system comprises a plurality of energy storage units that are connected in parallel, a battery management unit, and a power scheduling unit; and
the method for correcting the state of charge value comprises:

sending, by the battery management unit, parameter information of each of the energy storage units to the power scheduling unit, wherein the parameter information comprises an accumulated running duration and an accumulated power-off duration of the energy storage unit from a last correction time to a current time, and a current state of charge value of the energy storage unit;
determining, by the power scheduling unit based on accumulated running durations and accumulated power-off durations of the energy storage units, a target energy storage unit requiring correction from the energy storage units, wherein an accumulated running duration of the target energy storage unit is greater than or equal to a first time threshold, or an accumulated power-off duration of the target energy storage unit is greater than or equal to a second time threshold;
delivering, by the power scheduling unit, a power scheduling instruction to the target energy storage unit, to control the target energy storage unit to receive charging power or output discharging power; and
monitoring, by the battery management unit, a voltage and a state of charge value of target energy storage units; and correcting the state of charge value of the target energy storage unit when the voltage or the state of charge value of the target energy storage unit meets a specified condition.

**14.** The correction method according to claim 13, wherein after the determining, by the power scheduling unit based on accumulated running durations and accumulated power-off durations of the energy storage units, a target energy storage unit requiring correction, and before the delivering, by the power scheduling unit, a power scheduling instruction to the target energy storage unit, to control the target energy storage unit to receive charging power or output discharging power further comprise:

determining, by the power scheduling unit, a correction manner of the target energy storage unit based on the state of charge value of the target energy storage unit, wherein if the state of charge value of the target energy storage unit is greater than or equal to a first threshold, the correction manner of the target energy storage unit is charging-based correction; or if the state of charge value of the target energy storage unit is less than or equal to a second threshold, the correction manner of the target energy storage unit is discharging-based correction; and
the delivering, by the power scheduling unit, a power scheduling instruction to the target energy storage unit, to control the target energy storage unit to receive charging power or output discharging power comprises:
delivering, by the power scheduling unit, the power scheduling instruction to the target energy storage unit, to control the target energy storage unit requiring charging-based correction to receive the charging power and control the target energy storage unit requiring discharging-based correction to output the discharging power.

**15.** The correction method according to claim 14, wherein the specified condition is the following:

a voltage of the target energy storage unit requiring charging-based correction is greater than a first voltage threshold; or
a state of charge value of the target energy storage unit requiring charging-based correction is greater than a third threshold; or
a voltage of the target energy storage unit requiring discharging-based correction is less than a second voltage threshold; or
a state of charge value of the target energy storage unit requiring discharging-based correction is less than a fourth threshold, wherein
the first voltage threshold ranges from 3.32 V to 3.4 V, the second voltage threshold ranges from 2.5 V to 3.2 V, the third threshold ranges from 90% to 96%, and the fourth threshold ranges from 15% to 20%.

**16.** A method for correcting a state of charge value of an energy storage system, comprising:

receiving sent parameter information of each of energy storage units from a battery management unit, wherein the parameter information comprises an accumulated running duration and an accumulated power-off duration of the energy storage unit from a last correction time to a current time, and a current state of charge value of the energy storage unit;
determining, based on accumulated running durations and accumulated power-off durations of the energy storage units, a target energy storage unit requiring correction from the energy storage units, wherein an accumulated running duration of the target energy storage unit is greater than or equal to a first time threshold, or an accumulated power-off duration of the target energy storage unit is greater than or equal to a second time threshold; and
delivering a power scheduling instruction to the target energy storage unit, to control the target energy storage unit to receive charging power or output discharging power, so that the battery management unit monitors a voltage and a state of charge value of target energy storage units; and correcting the state of charge value of the target energy storage unit when the voltage or the state of charge value of the target energy storage unit meets a specified condition.

**17.** The correction method according to claim 16, wherein after the determining, based on accumulated running durations and accumulated power-off durations of the energy storage units, a target energy storage unit requiring correction from the energy storage units, and before the delivering a power scheduling instruction to the target energy storage unit, to control the target energy storage unit to receive charging power or output discharging power further comprise:

determining a correction manner of the target energy storage unit based on the state of charge value of the target energy storage unit, wherein if the state of charge value of the target energy storage unit is greater than or equal to a first threshold, the correction manner of the target energy storage unit is charging-based correction; or if the state of charge value of the target energy storage unit is less than or equal to a second threshold, the correction manner of the target energy storage unit is discharging-based correction; and
the delivering a power scheduling instruction to the target energy storage unit, to control the target energy storage unit to receive charging power or output discharging power comprises:
delivering the power scheduling instruction to the target energy storage unit, to control the target energy storage unit requiring charging-based correction to receive the charging power and control the target energy storage unit requiring discharging-based correction to output the discharging power.

**18.** The correction method according to claim 17, wherein the determining a correction manner of the target energy storage unit based on the state of charge value of the target energy storage unit comprises:
determining whether an external load that is electrically connected to the energy storage system has a charging requirement or a discharging requirement; and determining the correction manner of the target energy storage unit based on the state of charge value of the target energy storage unit when it is determined that the external load has no charging requirement or discharging requirement.

**19.** The method according to claim 18, further comprising:

in a process in which charging-based correction or discharging-based correction is performed for the target energy storage unit, determining whether the external load generates the charging requirement or the discharging requirement; and
if it is determined that the external load generates the charging requirement, controlling the target energy storage unit requiring charging-based correction to continue to receive the charging power and controlling the target energy storage unit requiring discharging-based correction to stop outputting the discharging power;

if it is determined that the external load generates the discharging requirement, controlling the target energy storage unit requiring discharging-based correction to continue to output the discharging power and controlling the target energy storage unit requiring charging-based correction to stop receiving the charging power; or
if it is determined that the external load has no charging requirement or discharging requirement, controlling the target energy storage unit requiring charging-based correction to continue to receive the charging power and controlling the target energy storage unit requiring discharging-based correction to continue to output the discharging power.

**20.** A method for correcting a state of charge value of an energy storage system, comprising:

sending parameter information of each of energy storage units to a power scheduling unit, wherein the parameter information comprises an accumulated running duration and an accumulated power-off duration of the energy storage unit from a last correction time to a current time, and a current state of charge value of the energy storage unit; and
monitoring a voltage and a state of charge value of target energy storage units; and correcting the state of charge value of the target energy storage unit when the voltage or the state of charge value of the target energy storage unit meets a specified condition.

**21.** The correction method according to claim 20, wherein the correcting the state of charge value of the target energy storage unit meets the following formula:

$$SOC_w = SOC_{w-1} + A + K^*(U_1 - U_2),$$

wherein
$SOC_w$ represents a corrected state of charge value, w represents a quantity of sampling periods, $SOC_{w-1}$ represents a state of charge value in a previous sampling period, A represents an ampere-hour integral between two sampling periods, K represents a convergence coefficient, $U_1$ represents a current voltage of the target energy storage unit, $U_2$ represents a table lookup voltage, and the table lookup voltage is obtained based on $SOC_{w-1}$ and a correspondence between a state of charge value and a voltage.

**22.** The correction method according to claim 20 or 21, further comprising:

monitoring whether the target energy storage unit requiring charging-based correction reaches a full-charge determining condition, and correcting the state of charge value of the target energy storage unit that reaches the full-charge determining condition to a first state of charge value, wherein
the full-charge determining condition is that the voltage of the target energy storage unit is greater than or equal to a charge cut-off voltage; or the full-charge determining condition is that a current of the target energy storage unit is less than or equal to a specified current threshold.

Power scheduling unit
103
Direct current-to-direct current converter
104
Battery module
1011
101
...


FIG. 1

Last correction time
Accumulated running duration
Accumulated power-off duration
State of charge value
Power limit
102
103
Battery management unit
Power scheduling unit
Power scheduling instruction
Power scheduling instruction
Direct current-to-direct current converter
104

FIG. 2

A battery management unit sends parameter information of each of energy storage units to a power scheduling unit, where the parameter information includes an accumulated running duration and an accumulated power-off duration of the energy storage unit from a last correction time to a current time, and a current state of charge value of the energy storage unit
201
The power scheduling unit determines, based on accumulated running durations and accumulated power-off durations of the energy storage units, a target energy storage unit requiring correction from the energy storage units, where an accumulated running duration of the target energy storage unit is greater than or equal to a first time threshold, or an accumulated power-off duration of the target energy storage unit is greater than or equal to a second time threshold
202
The power scheduling unit delivers a power scheduling instruction to the target energy storage unit, to control the target energy storage unit to receive charging power or output discharging power
203
The battery management unit monitors a voltage and a state of charge value of target energy storage units; and corrects the state of charge value of the target energy storage unit when the voltage or the state of charge value of the target energy storage unit meets a specified condition
204

FIG. 3

Start
A battery management unit sends parameter information of each of energy storage units to a power scheduling unit, where the parameter information includes an accumulated running duration and an accumulated power-off duration of the energy storage unit from a last correction time to a current time, and a current state of charge value of the energy storage unit
201
2021
Determine whether the accumulated running duration of the energy storage unit is greater than or equal to a first time threshold
No
2022
Determine whether the accumulated power-off duration of the energy storage unit is greater than or equal to a second time threshold
No
Yes
Yes
206
The power scheduling unit determines whether an external load that is electrically connected to an energy storage system has a charging requirement or a discharging requirement
No
Yes
TO FIG. 4B
TO FIG. 4B

FIG. 4A

CONT. FROM FIG. 4A
CONT. FROM FIG. 4A
205
The power scheduling unit determines a correction manner of the target energy storage unit based on a state of charge value of the target energy storage unit
The state of charge value is less than or equal to a second threshold
The state of charge value is greater than or equal to a first threshold
The correction manner is charging-based correction
The correction manner is discharging-based correction
2031
The power scheduling unit determines a priority sequence of target energy storage units requiring charging-based correction
2032
The power scheduling unit determines a priority sequence of target energy storage units requiring discharging-based correction
The power scheduling unit allocates power to the target energy storage units based on the correction manner and the priority sequence of the target energy storage units
2033
The battery management unit monitors a voltage and a state of charge value of the target energy storage units; and corrects the state of charge value of the target energy storage unit when the voltage or the state of charge value of the target energy storage unit meets a specified condition
204
TO FIG. 4C
TO FIG. 4C
TO FIG. 4C

FIG. 4B

CONT. FROM FIG. 4B
CONT. FROM FIG. 4B
CONT. FROM FIG. 4B
In a process in which charging-based correction or discharging-based correction is performed for the target energy storage unit, the power scheduling unit determines whether the external load generates a charging requirement or a discharging requirement
207
No
Yes
If it is determined that the external load generates the charging requirement, the power scheduling unit controls the energy storage unit requiring charging-based correction to continue to receive charging power and control the target energy storage unit requiring discharging-based correction to stop outputting discharging power
208
If it is determined that the external load generates the discharging requirement, the power scheduling unit controls the energy storage unit requiring discharging-based correction to continue to output discharging power and control the target energy storage unit requiring charging-based correction to stop receiving charging power
209
End

FIG. 4C

105
External load
Direct current-to-direct current converter
104
Battery module
1011
Battery module
Battery module
101
Charging-based correction
Direct current-to-direct current converter
104
Battery module
1011
Battery module
Battery module
101
Discharging-based correction
Direct current-to-direct current converter
104
Battery module
1011
Battery module
Battery module
101
No correction required

FIG. 5

Direct current-to-direct current converter
104
Battery module
1011
Battery module
⋮
101
Battery module
Corrected
Direct current-to-direct current converter
104
Battery module
1011
Battery module
⋮
101
Battery module
Corrected
Direct current-to-direct current converter
104
Battery module
1011
Battery module
⋮
101
Battery module
No correction required

FIG. 6

Direct current-to-direct current converter
104
Battery module
1011
Battery module
101
Battery module
Charging-based correction
Direct current-to-direct current converter
104
Battery module
1011
Battery module
101
Battery module
Charging-based correction
Direct current-to-direct current converter
104
Battery module
1011
Battery module
101
Battery module
No correction required

FIG. 7

Direct current-to-direct current converter
104
Battery module
1011
Battery module
101
Battery module
Discharging-based correction
Direct current-to-direct current converter
104
Battery module
1011
Battery module
101
Battery module
Discharging-based correction
Direct current-to-direct current converter
104
Battery module
1011
Battery module
101
Battery module
No correction required

FIG. 8

**INTERNATIONAL SEARCH REPORT**

International application No. **PCT/CN2022/084037**

**A. CLASSIFICATION OF SUBJECT MATTER**

G01R 31/382(2019.01)i

According to International Patent Classification (IPC) or to both national classification and IPC

**B. FIELDS SEARCHED**

Minimum documentation searched (classification system followed by classification symbols)

G01R

Documentation searched other than minimum documentation to the extent that such documents are included in the fields searched

Electronic data base consulted during the international search (name of data base and, where practicable, search terms used)

CNTXT, ENTXT, ENTXTC, DWPI, CNKI: 电池, 储能, 荷电状态, 容量, SOC, 校正, 修正, 计算, 评估, 估算, 顺序, 排序, 优先级, 负荷, 阈值, battery, cell, storage, state, adjust, rectify, estimate, rank, load, threshold

**C. DOCUMENTS CONSIDERED TO BE RELEVANT**

| Category* | Citation of document, with indication, where appropriate, of the relevant passages | Relevant to claim No. |
|---|---|---|
| PX | CN 114035064 A (WUHAN WEINENT BATTERY ASSETS CO., LTD.) 11 February 2022 (2022-02-11) description, paragraphs [0004]-[0023] | 1, 12-13, 16, 20 |
| X | CN 112078429 A (CHANGSHA INTELLIGENT DRIVING INSTITUTE LTD.) 15 December 2020 (2020-12-15) description, paragraphs [0025]-[0099], and figures 1-8 | 1-3, 5-9, 11-20, 22 |
| Y | CN 112078429 A (CHANGSHA INTELLIGENT DRIVING INSTITUTE LTD.) 15 December 2020 (2020-12-15) description, paragraphs [0025]-[0099], and figures 1-8 | 4, 10, 21 |
| Y | CN 109633460 A (DONGFENG HANGSHENG (WUHAN) AUTOMOBILE CONTROL SYSTEM CO., LTD.) 16 April 2019 (2019-04-16) description, paragraphs [0032]-[0033], [0038] and [0042]-[0044] | 4, 21 |
| Y | CN 109212420 A (SHENZHEN CLOU ELECTRONICS CO., LTD.) 15 January 2019 (2019-01-15) description, paragraph [0128] | 10 |

☑ Further documents are listed in the continuation of Box C. ☑ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **26 May 2022** | **09 June 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

INTERNATIONAL SEARCH REPORT

International application No.
PCT/CN2022/084037

C. DOCUMENTS CONSIDERED TO BE RELEVANT

| Category* | Citation of document, with indication, where appropriate, of the relevant passages | Relevant to claim No. |
|---|---|---|
| A | CN 107632268 A (ELECTRIC POWER RESEARCH INSTITUTE, GUANGDONG POWER GRID CORP.) 26 January 2018 (2018-01-26) entire document | 1-22 |
| A | US 2013229154 A1 (ACCUMULATEURS FIXES) 05 September 2013 (2013-09-05) entire document | 1-22 |

Form PCT/ISA/210 (second sheet) (January 2015)

## INTERNATIONAL SEARCH REPORT
**Information on patent family members**

International application No.
**PCT/CN2022/084037**

| Patent document cited in search report | Publication date (day/month/year) | Patent family member(s) | Publication date (day/month/year) |
|---|---|---|---|
| CN 114035064 A | 11 February 2022 | None | |
| CN 112078429 A | 15 December 2020 | None | |
| CN 109633460 A | 16 April 2019 | CN 109633460 B | 19 March 2021 |
| CN 109212420 A | 15 January 2019 | None | |
| CN 107632268 A | 26 January 2018 | None | |
| US 2013229154 A1 | 05 September 2013 | US 9316693 B2 | 19 April 2016 |
| | | EP 2634591 A1 | 04 September 2013 |
| | | EP 2634591 B1 | 19 July 2017 |
| | | FR 2987703 A1 | 06 September 2013 |
| | | FR 2987703 B1 | 12 December 2014 |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CN 202110377624